# EUROPÄISCHE PATENTSCHRIFT

(11) **EP 3 910 662 B1**
(45) Veröffentlichungstag und Bekanntmachung des Hinweises auf die Patenterteilung: **09.08.2023**
(21) Anmeldenummer: 21163946.3
(22) Anmeldetag: 22.03.2021
(51) Int. Cl.: H01J 37/34, C23C 14/35

(54) **MAGNETRONANORDNUNG**
MAGNETRON ASSEMBLY
AGENCEMENT MAGNÉTIQUE

(30) Priorität: 13.05.2020 DE 102020112979
(43) Veröffentlichungstag der Anmeldung: 17.11.2021
(73) Patentinhaber: VON ARDENNE Asset GmbH & Co. KG, 01328 Dresden (DE)
(72) Erfinder: MOSSHAMMER, Steffen, 01734 Rabenau (DE); RANK, Rolf, 04105 Leipzig (DE)
(74) Vertreter: Viering, Jentschura & Partner mbB Patent- und Rechtsanwälte

(56) Entgegenhaltungen:
- EP-A1- 3 137 646
- EP-B1- 3 137 646
- DE-A1-102014 109 991
- US-A1- 2011 155 568
- US-A1- 2014 097 080

## Beschreibung

Verschiedene Ausführungsbeispiele betreffen eine Magnetronanordnung.

Im Allgemeinen können Werkstücke oder Substrate prozessiert, z.B. bearbeitet, beschichtet, erwärmt, geätzt und/oder strukturell verändert werden. Ein Verfahren zum Beschichten eines Substrats ist beispielsweise die Kathodenzerstäubung (das so genannte Sputtern). Mittels Sputterns kann beispielsweise eine Schicht oder können mehrere Schichten auf einem Substrat abgeschieden werden. Dazu kann mittels einer Kathode ein plasmabildendes Gas ionisiert werden, wobei mittels des dabei gebildeten Plasmas ein abzuscheidendes Material (Targetmaterial) der Kathode zerstäubt werden kann. Das zerstäubte Targetmaterial kann anschließend zu einem Substrat gebracht werden, an dem es sich abscheiden und eine Schicht bilden kann.

Modifikationen der Kathodenzerstäubung sind das Sputtern mittels eines Magnetrons, das so genannte Magnetronsputtern oder das so genannte reaktive Magnetronsputtern. Dabei kann das Bilden des Plasmas mittels eines Magnetfeldes unterstützt werden, wobei mittels des Magnetfeldes beispielsweise die Ionisationsrate des plasmabildenden Gases erhöht werden kann. Zum Erzeugen des Magnetfeldes kann relativ zu der Kathode ein Magnetsystem derart angeordnet sein oder werden, dass an der Oberfläche des Targetmaterials (Targetoberfläche) ein Plasmakanal, ein so genannter Race-Track, ausgebildet werden kann, in dem sich Plasma bilden kann. Dabei kann das Targetmaterial an den Stellen zerstäubt werden, an denen der Plasmakanal verläuft.

Wird während des Sputterns das Targetmaterial zerstäubt und dabei verbraucht, kann das Targetmaterial dünner werden, wobei der Abstand der Oberfläche des Targetmaterials zu dem Magnetsystem reduziert werden kann. Aus dem veränderten Abstand kann eine Änderung des Magnetfeldes auf der Targetoberfläche resultieren, was das Zerstäuben von Targetmaterial und damit das Abscheiden einer Schicht aus dem zerstäubten Targetmaterial beeinflussen kann. Anschaulich kann sich eine Abscheidungscharakteristik aufgrund des Verbrauchs an Targetmaterial im Verlauf des Sputterns verändern.

Ein gleichmäßiges Zerstäuben von Targetmaterial kann daher ein präzises Einrichten des Magnetsystems relativ zu der Kathode erfordern, um anschaulich eine möglichst gleichmäßige Geometrie (z.B. einer magnetischen Flussdichte oder eines magnetischen Feldgradienten) des Magnetfelds auf der Targetoberfläche zu erhalten.

Bekannte Beispiele von Magnetronsystemen mit rotierendem Target, bei denen die Position der Magnete in Bezug auf das Target verändert wird sind aus EP 3 137 646 A1, DE 10 2014 109991 A1, US 2014/097080 A1 und US 2011 /155568 A1 bekannt.

Durch die Erfindung, definiert von der Magnetronanordnung gemäß Anspruch 1, wird unter anderem ein gleichmäßigeres Zerstäuben eines Targetmaterials aufgrund eines präziseren Einrichtens des Magnetsystems relativ zu der Kathode erreicht. Weitere erfinderische Ausführungsformen sind in den abhängigen Ansprüchen definiert.

Ein Aspekt verschiedener Ausführungsformen kann anschaulich darin gesehen werden, dass ein verstellbares Magnetfeld bereitgestellt wird. Mittels Stellens des Magnetfeldes kann ein Zerstäuben des Targetmaterials beeinflusst werden, beispielsweise derart, dass ein möglichst gleichmäßiges Zerstäuben und/oder Beschichten erfolgen kann. Zum Stellen des Magnetfeldes kann beispielsweise eine Lage (d.h. Position und/oder Ausrichtung) der Magnete des Magnetsystems relativ zueinander und/oder relativ zu dem Target gestellt werden.

Gemäß verschiedenen Ausführungsformen wurde anschaulich erkannt, dass die herkömmlicherweise zum Stellen des Magnetfeldes verwendete Elektronik zu fehleranfällig und zu unhandlich ist. Die verwendete Elektronik ist im Betrieb beständig einer erhöhten Belastung ausgesetzt, da diese wasserumflossen und elektrischen Schwankungen ausgesetzt ist. Anschaulich wurde erkannt, dass dies verbesserte werden kann, indem die elektrische Wechselwirkungskette verbessert wird. Zu der Wechselwirkungskette gehören beispielsweise die Energieversorgungskette, d.h. die Kette von der Energieerzeugung bis zum Energieverbrauch, und die Kommunikationskette.

Die gemäß verschiedenen Ausführungsformen bereitgestellte elektrische Wechselwirkungskette ist kompakter, zuverlässiger und weniger komplex.

Beispielsweise wurde erkannt, dass eine Energieerzeugung innerhalb des rotierenden Targets die Energieversorgungskette erheblich verkürzt und die Wartungsintervalle deutlich vergrößert. In dem Zusammenhang wurde erkannt, dass eine Energieerzeugung innerhalb des Targets zuverlässiger wird, wenn der Energieverbrauch für ein Stellen des Magnetfeldes verringert wird. Unter anderem wurde erkannt, dass es eine geringere Dimensionierung des Energieverbrauchs ermöglicht, auch die Dimensionierung der Energieerzeugung zu verringern, so dass alle Komponenten der Energieversorgungskette kompakter werden können, was das Risiko für Ausfälle verringert, die Energieversorgung zuverlässiger macht und Reparaturen erleichtert.

Gemäß verschiedenen Aspekten werden anschaulich mehrere identisch aufgebaute Magnetsystemgruppen (auch als Magnetbaugruppe bezeichnet) bereitgestellt, von denen jede Magnetsystemgruppe mehrere Magnete samt Stellantrieb aufweist, und somit schnell und als Baugruppe kostengünstig getauscht bzw. betrieben werden können.

Gemäß verschiedenen Aspekten werden anschaulich eine Vielzahl Magnetbaugruppen bereitgestellt, die eine möglichst geringe Anzahl Magnete aufweisen, was deren Gewicht und damit den Energieverbrauch pro Stellvorgang, der das Magnetfeld stellt, verringert. Dies erreicht, dass der Generator weniger Leistung bereitstellen muss, so dass der Generator kompakter gebaut werden kann.

Es zeigen
- Figur 1: bis 6 und 8 jeweils eine Magnetronanordnung gemäß verschiedenen Ausführungsformen in verschiedenen schematischen Ansichten;
- Figur 7: eine Magnetronanordnung gemäß verschiedenen Ausführungsformen in einem schematischen Verschaltungsdiagramm; und
- Figur 9: das Steuersignal der Magnetronanordnung gemäß verschiedenen Ausführungsformen in einem schematischen Diagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung (z.B. ein Signal) übertragen werden kann. Beispielsweise können zwei miteinander gekoppelte Elemente eine Wechselwirkung miteinander austauschen, z.B. eine mechanische, hydrostatische, thermische und/oder elektrische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Als Steuern kann eine beabsichtigte Beeinflussung eines Systems verstanden werden. Dabei kann der momentane Zustand des Systems (auch als Ist-Zustand bezeichnet) gemäß einer Vorgabe (auch als Soll-Zustand bezeichnet) verändert werden. Regeln kann als Steuern verstanden werden, wobei zusätzlich einer Zustandsänderung des Systems durch Störungen entgegengewirkt wird. Anschaulich kann die Steuerung eine nach vorn gerichtete Steuerstrecke aufweisen und somit anschaulich eine Ablaufsteuerung implementieren, welche eine Eingangsgröße (z.B. die Vorgabe) in eine Ausgangsgröße umsetzt. Die Steuerstrecke kann aber auch Teil eines Regelkreises sein, so dass eine Regelung implementiert wird. Die Regelung weist im Gegensatz zu der reinen vorwärts gerichteten Ablaufsteuerung eine fortlaufende Einflussnahme der Ausgangsgröße auf die Eingangsgröße auf, welche durch den Regelkreis bewirkt wird (Rückführung). Mit anderen Worten kann alternativ oder zusätzlich zu der Steuerung eine Regelung verwendet werden bzw. alternativ oder zusätzlich zu dem Steuern ein Regeln erfolgen. Der Zustand des Systems (auch als Arbeitspunkt bezeichnet) kann von einer oder mehr als einer Regelgröße des Systems repräsentiert werden, deren Ist-Wert den Ist-Zustand des Systems und deren Soll-Wert (auch als Führungswert bezeichnet) den Soll-Zustand des Systems repräsentiert. Bei einer Regelung wird ein Ist-Zustand des Systems (z.B. basierend auf einer Messung ermittelt) mit dem Soll-Zustand des Systems verglichen und die eine oder mehr als eine Regelgröße mittels einer entsprechenden Stellgröße (unter Verwendung eines Stellglieds) derart beeinflusst, dass die Abweichung des Ist-Zustands von dem Soll-Zustand des Systems minimiert wird.

Das Steuern und/oder Regeln kann gemäß verschiedenen Ausführungsformen mittels einer Steuervorrichtung implementiert werden. Der Begriff "Steuervorrichtung" kann als jede Art einer Logik implementierenden Entität verstanden werden, die beispielsweise eine Verschaltung und/oder einen Prozessor aufweisen kann, welche Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein, um den Betrieb eines Systems (z.B. seines Arbeitspunkts) zu steuern. Der Arbeitspunkt kann den Punkt im Kennfeld oder auf der Kennlinie eines technischen Gerätes beschreiben, der aufgrund der Systemeigenschaften und einwirkenden äußeren Einflüsse und Parameter des Gerätes eingenommen wird. Der Arbeitspunkt kann anschaulich beschreiben, welchen Betriebszustand (d.h. Ist-Zustand) das Gerät aufweist.

Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden, beispielsweise auch virtuelle Prozessoren (oder eine virtuelle Maschine) oder eine Vielzahl dezentraler Prozessoren, die beispielsweise mittels eines Netzwerks miteinander verbunden sind, beliebig räumlich verteilt sind und/oder beliebige Anteile an der Implementierung der jeweiligen Funktionen haben (z.B. Rechenlastverteilung unter den Prozessoren). Dasselbe gilt im Allgemeinen für eine anders implementierte Logik zur Implementierung der jeweiligen Funktionen. Es versteht sich, dass einer oder mehrere der hierin detailliert beschriebenen Verfahrensschritte von einem Prozessor ausgeführt (z.B. realisiert) werden können, durch eine oder mehrere spezifische Funktionen, die von dem Prozessor ausgeführt werden.

Das Steuern und/oder Regeln kann aufweisen, dass von der Steuervorrichtung Instruktionen als Informationen an das Stellglied übertragen werden, welche von dem Stellglied umgesetzt werden (mittels Stellens des Stellglieds). Dazu kann das Stellglied in analoger Weise einen Prozessor aufweisen, welcher eingerichtet ist, die Instruktionen zu interpretieren und gemäß der entsprechenden Funktion des Stellglieds umzusetzen. Als Beispiel kann eine Instruktion einen Soll-Wert aufweisen, welche das Stellglied einnehmen soll. Als anderes Beispiel kann eine Instruktion eine Soll-Veränderung aufweisen, welche das Stellglied ausführen soll.

Die Übertragung einer Information (auch als Informationsübertragung oder Kommunikation bezeichnet) kann gemäß verschiedenen Ausführungsformen gemäß einem Kommunikationsprotokoll (KP) erfolgen. Die Informationsübertragung kann aufweisen, eine Nachricht, welche die Information aufweist, gemäß dem Kommunikationsprotokoll zu erzeugen und/oder zu übermitteln. Das Kommunikationsprotokoll kann anschaulich eine Vereinbarung, nach der die Informationsübertragung zwischen zwei oder mehreren Parteien abläuft bezeichnen. In seiner einfachsten Form kann das Kommunikationsprotokoll definiert werden als eine Menge von Regeln, welche die Syntax, Semantik und Synchronisation der Informationsübertragung festlegen. Das oder die eingesetzten Kommunikationsprotokolle (z.B. ein oder mehrere Netzwerkprotokolle) können grundsätzlich beliebig ausgewählt werden und können (müssen aber nicht) gemäß dem OSI (Open System Interconnect)-Referenzmodell konfiguriert sein. In den jeweiligen Protokollschichten können ebenfalls beliebige Protokolle eingesetzt werden.

Der Begriff "Sputtern" bezeichnet das Zerstäuben eines Materials (auch als Beschichtungsmaterial oder Targetmaterial bezeichnet) mittels eines Plasmas. Die zerstäubten Bestandteile des Targetmaterials werden somit voneinander separiert und können beispielsweise zum Bilden einer Schicht woanders angelagert werden. Das Sputtern kann mittels einer sogenannten Sputtervorrichtung erfolgen, welche ein Magnetsystem aufweisen kann (dann auch als Magnetron bezeichnet).

Zum Sputtern kann das Magnetron in einer Vakuum-Prozessierkammer angeordnet werden, so dass das Sputtern in einem Vakuum erfolgen kann. Dazu können die Umgebungsbedingungen (die Prozessbedingungen) innerhalb der Vakuum-Prozessierkammer (z.B. Druck, Temperatur, Gaszusammensetzung, usw.) während Sputterns eingestellt oder geregelt werden. Die Vakuum-Prozessierkammer kann beispielsweise luftdicht, staubdicht und/oder vakuumdicht eingerichtet sein oder werden, so dass innerhalb der Vakuum-Prozessierkammer eine Gasatmosphäre mit einer vordefinierten Zusammensetzung oder einem vordefinierten Druck (z.B. gemäß einem Sollwert) bereitgestellt werden kann. Beispielsweise kann innerhalb der Vakuum-Prozessierkammer ein ionenbildendes Gas (Prozessgas) oder ein Gasgemisch (z.B. aus einem Prozessgas und einem Reaktivgas) in der Prozesskammer bereitgestellt sein oder werden. Bei einem reaktiven Magnetronsputtern kann das zerstäubte Material beispielsweise mit einem Reaktivgas reagiert und das Reaktionsprodukt abgeschieden werden.

Um das Targetmaterial effektiv zu zerstäuben (auch als Sputtern bezeichnet), kann das Targetmaterial um das Magnetsystem herumgedreht werden. Dazu kann das Targetmaterial rohrförmig, als so genanntes Rohrtarget, eingerichtet sein, wobei das Magnetsystem im Inneren des Rohrtargets angeordnet sein kann, so dass das Rohrtarget um das Magnetsystem gedreht werden kann. Das Rohrtarget kann beispielsweise ein Rohr aufweisen auf dem das Targetmaterial als Schicht auf einer äußeren Mantelfläche des Rohrs befestigt sein kann und die Mantelfläche des Rohrs teilweise bedecken kann. Das Rohrtarget kann aber auch aus dem Targetmaterial gebildet sein.

Das Zerstäuben von Targetmaterial mittels Sputterns kann mit einer räumlichen Verteilung erfolgen, wobei die räumliche Verteilung des zerstäubten Targetmaterials von dem Ist-Zustand des Sputterns abhängen kann. Parameter (die sogenannten Prozessparameter) des Ist-Zustands des Sputterns weisen beispielsweise auf: die Zusammensetzung und/oder Temperatur des Plasmas, die Beschaffenheit des Targetmaterials, die Prozessspannung; die Form und/oder Geometrie des Magnetfeldes und/oder der Druck des ionenbildenden Gases. Mittels Anpassens des Magnetsystems bzw. des damit erzeugten Magnetfeldes können Abweichungen vom Soll-Zustand des Sputterns (auch als Sputterprozess bezeichnet) reduziert werden, was die Eigenschaften der abgeschiedenen Schicht verbessert. Die Prozessspannung kann an dem Targetmaterial anliegen, welches im Betrieb die Funktion der Kathode zum Bilden des Plasmas implementiert. Daher wird das Target auch als Kathode bezeichnet (im drehbaren Fall auch dann auch als Rohrkathode bezeichnet).

Zum Sputtern kann in einer Vakuum-Prozessierkammer gemäß verschiedenen Ausführungsformen eine Magnetronanordnung mit einem Rohrtarget und einem Magnetsystem in dem Rohrtarget angeordneten werden. Das Rohrtarget kann an gegenüberliegenden Endabschnitten mittels so genannter Endblöcke drehbar gelagert sein oder werden, wobei die Endblöcke ein Versorgen der Rohrtarget (z.B. mit elektrischer Leistung und Kühlfluid) bereitstellen können.

Allgemeiner gesprochen wird hierin auf eine Lageranordnung Bezug genommen, welche zum Lagern eines Rohrtargets einen oder mehr als einen Endblock aufweisen kann.

Weist die Lageranordnung zwei Endblöcke auf, kann jeweils einer der Endblöcke (der sogenannte Antriebsendblock) einen Antriebsstrang aufweisen, der mit einem Antrieb (auch als Targetantrieb bezeichnet) zum Drehen des Rohrtargets gekuppelt ist; und der jeweils andere der Endblöcke (der sogenannte Medienendblock) kann eine Fluidleitung zum Zuführen und Abführen von Kühlfluid (z.B. ein wasserbasiertes Gemisch) aufweisen, welches durch das Target hindurch geleitet werden kann. Die zwei Endblöcke werden beispielsweise an einer Kammerdecke (d.h. einem Kammerdeckel) hängend montiert.

Es kann allerdings auch genau ein Endblock (auch als Kompaktendblock bezeichnet) verwendet werden, welcher den Antriebsstrang und die Fluidleitung aufweist und somit die Funktionen eines Antriebsendblocks und eines Medienendblocks gemeinsam bereitstellt. Die dem Kompaktendblock gegenüberliegende Seite des Rohrtargets kann beispielsweise frei auskragen (d.h. frei hängen), was als Cantilever-Konfiguration bezeichnet wird. Der Kompaktendblock kann in Cantilever-Konfiguration an einer Seitenwand der Vakuumkammer montiert sein, durch welche hindurch die Drehachse des Rohrtargets hindurch erstreckt ist. Die dem Kompaktendblock gegenüberliegende Seite des Rohrtargets kann aber auch mittels eines Lagerbocks (anschaulich ein Gegenlager) gelagert sein, was als Lagerbock-Konfiguration bezeichnet wird. Der Lagerbock kann auch mittels eines passiven Endblocks bereitgestellt sein, d.h. eines Endblocks, welcher weder Energie noch Material mit dem Rohrtarget austauscht, sondern dieses nur abstützt.

Im Fall eines Plattentargets, das nicht bewegbar (z.B. nicht drehbar) gelagert sein muss, kann die Lageranordnung ein starres Gestell aufweisen, welches das Plattentarget hält. Das Plattentarget kann beispielsweise eine oder mehr als eine Platte (z.B. Kachel) aufweisen, wobei mehrere Platten nebeneinandergehalten werden.

Die Lageranordnung kann allgemein (z.B. bei einem Rohrtarget und einem Plattentarget) einen Träger aufweisen (auch als Magnetträger bezeichnet), welcher zum Halten einer oder mehr als einer Magnetsystembaugruppe eingerichtet ist. Der Magnetträger kann beispielsweise hohl sein (z.B. ein Rohr aufweisend) und stirnseitig mit einem Endblock, welcher den Magnetträger hält, fluidleitend gekoppelt sein (z.B. mit dessen Fluidleitung), so dass dieses mit dem Endblock das Kühlfluid austauschen kann. Auf der dem Endblock gegenüberliegenden Seite kann das Rohr beispielsweise stirnseitig verschlossen sein und dort eine seitliche Öffnung aufweisen, durch welche das Kühlfluid hindurchtreten kann. Der Magnetträger kann rund sein oder mehreckig, z.B. ein Rundrohr oder ein Kantrohr aufweisend.

Ein Magnet kann ein magnetisiertes Material mit einer Magnetisierung aufweisen und anschaulich als Dauermagnet eingerichtet sein. Beispielsweise kann der Magnet einen Seltenerdmagnet (wie Neodym-Eisen-Bor (NdFeB)) oder Samarium-Kobalt (SmCo)), einen Ferrit-Magnet, einen Bismanol-Magnet und/oder einen Aluminium-Nickel-Kobalt-Magnet aufweisen.

Eine Trägerlanze (beispielsweise ein Lanzenrohr) kann einen Durchmesser (senkrecht zur Drehachse) in einem Bereich von 5 cm ungefähr bis ungefähr 50 cm aufweisen, z.B. in einem Bereich von 10 cm ungefähr bis ungefähr 30 cm.

Die Trägerlanze und/oder das Magnetsystem können eine Länge (Ausdehnung entlang der Drehachse) in einem Bereich von 1 m ungefähr bis ungefähr 6 m aufweisen, z.B. in einem Bereich von 2 m ungefähr bis ungefähr 5 m.

Das Magnetsystem kann beispielsweise ein oder mehr als ein Segment (auch als Magnetsystemsegment oder als Magnetsystemgruppe bezeichnet) aufweisen. Die Magneten jeder Magnetsystemgruppe können in drei Magnetreihen angeordnet sein, wobei jede Magnetreihe einen oder mehr als einen Magneten (Magneten) aufweisen kann. Jeder Magnet des Magnetsystems kann beispielsweise ungefähr 1 cm breit sein, so dass eine Magnetreihe ungefähr 100 Magnete pro Meter aufweisen kann.

Ein in dem Rohrtarget angeordnetes Magnetsystem kann derart mit den Endblöcken gekuppelt sein, dass das Magnetsystem beim Drehen des Rohrtargets in einer festen Lage bezüglich der Endblöcke verbleibt. Beispielsweise kann das Magnetsystem an einem so genannten Trägerrohr (auch als Trägerlanze bezeichnet), welches zwischen den beiden Endblöcken verläuft, befestigt sein.

Der Träger kann optional gleichzeitig als Lanzenrohr für die Kühlfluideinleitung dienen. Anschaulich kann das Kühlfluid innerhalb des Lanzenrohrs zugeführt und zwischen Lanzenrohr und Target zurückgeführt werden. Dabei kann das das Magnetsystem vom Kühlfluid umflossen werden. Bauteile, die in dem Target angeordnet sind, können daher ebenso vom Kühlfluid umflossen werden. An den vom Kühlfluid umflossenen Bauteilen kann es zu Korrosion kommen, was zusätzliche Anforderungen an Materialien stellen kann, die in den vom Kühlfluid umflossenen Bauteilen verwendeten werden (wie z.B. Korrosionsfestigkeit).

Das Target und das Kühlfluid können zum Sputtern mit Spannungen größer als ungefähr 50 V beaufschlagt werden. Anschaulich kann zum Sputtern an das Target eine elektrische Spannung (auch als Prozessspannung bezeichnet) angelegt werden, wobei das Kühlfluid mit dem Target elektrisch gekoppelt sein kann, so dass das Kühlfluid und das Target ein im Wesentlichen gleiches elektrisches Potential aufweisen können. Die beim Sputtern umgesetzte Leistung (Sputterleistung) kann von der Größe (z.B. der Länge) des Rohrtargets abhängen und kann in einem Bereich von ungefähr 2 kW pro Meter bis ungefähr 12 kW pro Meter (des Rohrtargets) liegen, wobei optional eine Wechselspannung oder gepulste Gleichspannung als Prozessspannung eingesetzt werden kann. In Verbindung mit der Drehung des Targets während des Sputterns können stark schwankende elektrische Felder (z.B. elektrische Wechselfelder) erzeugt werden, die Bauteile in der Umgebung des Targets belasten und/oder schädigen können.

Gemäß verschiedenen Ausführungsformen wird ein justierbares Magnetron bereitgestellt, welches eine verbesserte Stromversorgung und/oder Kommunikation bzw. Steuerung aufweist.

Anschaulich wird mittels eines Generators elektrischer Strom aus der Rotationsbewegung (auch als Drehbewegung bezeichnet) des Targets gewonnen. Die Datenkommunikation kann beispielsweise über eine optische oder kapazitive Kopplungsstrecke an der Stirnseite des Targets erfolgen.

Gemäß verschiedenen Ausführungsformen wird die Primärstromversorgung ausschließlich mittels des Generators (d.h. mittels Induktion), z.B. ohne ein Primärstromversorgung durch Batterien, bereitgestellt. Dies erreicht, dass kein Nachladen von Batterien bzw. keine dauerhafte Speicherung der Leistung benötigt wird. Die Leistung ist beispielsweise nur bei Betrieb des Magnetrons verfügbar.

Gemäß verschiedenen Ausführungsformen wird ein verstellbares Magnetrons (mit Magnetverstellung) bereitgestellt, welches mit geringem Energieverbrauch zu bewerkstelligen ist, um Energiequellen ohne Batterie oder Batteriepufferung nutzen zu können (z.B. durch Umwandlung der mechanischen Energie der Rotation des Rohrtargets in elektrische Energie mittels eines Generators). Die bereitgestellte Magnetverstellung ist auch für starke Magnetsysteme geeignet.

Das Magnetsystem des Magnetrons weist ein Mittelstück und zwei Endstücken, zwischen denen das Mittelstück angeordnet ist, auf. Jedes der Endstücke verbindet die außenliegenden magnetischen Pole des Mittelstücks miteinander, so dass ein in sich geschlossener Race-Track entsteht. Gemäß verschiedenen Ausführungsformen weist das Mittelstück mehrere Einzelsegmente (auch als Magnetsystemsegmente bezeichnet) auf. Jedes Magnetsystemsegment weist eine Rückschlussplatte, einen magnetischen Innenpol und zwei magnetische Außenpole auf. Das Mittelstück weist eine Anzahl von k Magnetsystemsegmenten auf (wobei k>1, beispielsweise k≥10, beispielsweise k≥50). Die Aneinanderreihung aller k Magnetsystemsegmente ergibt das Mittelstück. Magnete einander unmittelbar benachbarter Magnetsystemsegmente können relativ zueinander beweglich gelagert sein. Das Magnetsystem kann optional in einem Gehäuse angeordnet sein.

Das Magnetron weist eine Ansteuereinheit (auch als Steuervorrichtung bezeichnet) und eine Verstelleinheit (auch als Stellglied bezeichnet) auf, welche mittels der Ansteuereinheit bewegt wird. Das Antriebsprinzip der Ansteuereinheit kann aufweisen: einen Spindelantrieb, einen Zahnriemenantrieb, einen Antrieb mittels Zahnstange. Die Verstelleinheit kann einen Aktuator aufweisen oder daraus gebildet sein, der eine Kraft auf einen Gleitkeil ausübt. Mittels der Gleitebene des Gleitkeils wird ein Stempel derart bewegt, dass dadurch die Höhe der Magneten eines Magnetsystemsegments verändert wird. Alternativ kann der Aktuator die Kraft auf ein x-förmiges Hubelement (z.B. ein Scherengetriebe) übertragen, um die Höhe (auch als

Segmenthöhe bezeichnet) der Magneten eines Magnetsystemsegments zu verändern.

Bevorzugt kann das Getriebe zur Einstellung der Segmenthöhe selbsthemmend eingerichtet sein.

Als Beispiel können von k Magnetsystemsegmenten, jedes Magnetsystemsegment eine Verstelleinheit aufweisen (auch als aktives Magnetsystemsegment bezeichnet), so dass jedes der aktiven Magnetsystemsegmente individuell verstellbar sein kann. Optional kann zwischen zwei einander unmittelbar benachbarten aktiven Magnetsystemsegmenten, d.h. die ein Stellglied aufweisen, ein oder mehr als ein Magnetsystemsegment ohne Stellglied angeordnet sein (auch als passives Magnetsystemsegment bezeichnet), dessen Magneten bzw. dessen Rückschlussplatte von den zwei aktiven Magnetsystemsegmenten getragen werden (in diesem Fall können benachbarte Magnetsystemsegmente beweglich miteinander mechanisch gekoppelt sein). Beispielsweise kann jedes p-te Magnetsystemsegment des Magnetsystems ein passives Magnetsystemsegment sein. Mit anderen Worten muss nicht jedes der Magnetsystemsegmente notwendigerweise ein Stellglied aufweisen. Dazu kann zwischen den aktiven Magnetsystemsegmenten und dem einen oder mehr als einen passiven Magnetsystemsegment eine mechanische Kopplung vorliegen.

Aufgrund der mechanischen Kopplung werden Magneten einander unmittelbar benachbarter Magnetsystemsegmente in korreliert miteinander verstellt (vergleichbar zu einer Kettenlinie). Beispiele der mechanischen Kopplung der Magnetsystemsegmente untereinander können wie folgt eingerichtet sein: mechanisch starr (z.B. als Gelenk oder Kettenglied), mechanisch elastisch (z.B. über eine Blattfeder oder elastische Platte), eine Kombination aus beidem. Die Bewegung der Rückschlussplatte bzw. der Magnete eines Magnetsystemsegments kann optional mittels einer mechanischen Führung des Magnetsystemsegments (z.B. einer Schiene) geführt sein oder werden, um ein Verkippen zu hemmen.

Das Magnetsystem kann somit k Verstelleinheiten aufweisen, von denen jede Verstelleinheit einem aktiven Magnetsystemsegment zugeordnet ist. Alternativ kann das Magnetsystem k+k/(p-1) Magnetsystemsegmente aufweisen, d.h. d.h. k Verstelleinheiten.

Die Verstelleinheit kann einen Motor aufweisen, der mit einem Getriebe verbunden sein kann. Das Getriebe muss aber nicht notwendigerweise vorhanden sein.

Die Verstelleinheiten können seriell adressiert und über einen Kommunikationsbus gesteuert werden. Für den Fall passiver Magnetsystemsegmente werden diese mittels der unmittelbar benachbarten Magnetsystemsegmente über eine mechanische Kopplung in gleicher Weise aber geringerer Auslenkung verstellt (vergleichbar zu einer Kettenlinie).

Gemäß verschiedenen Ausführungsformen erfordert die Verstellung der Magnetsystemsegmente weniger Leistung als die Verstellung (z.B. Deformation) des gesamten Mittelstücks. Demzufolge können sehr kleine Motoren verwendet werden. Getriebe sind nicht zwingend erforderlich. Die benötigte Energie ist entsprechend reduziert. Aufgrund des kompakten Aufbaus können die Verstellpositionen flexibel und entsprechend den aktuellen Anforderungen, z.B. der Schichtgleichmäßigkeit, gewählt werden. Statt mechanisch festgelegter Stellpositionen können die Stellpositionen flexibel an die Aufgabenstellung angepasst werden. Durch eine geeignete Ansteuerung oder Verbindung benachbarter Magnetsystemsegmente kann eine quasi kontinuierliche Änderung des Magnetfeldes auf der Targetoberfläche erreicht werden. Die Komplexität und die Kosten des Gesamtaufbaus des Magnetrons gemäß verschiedenen Ausführungsformen sind aufgrund der Verwendung vieler Wiederholteile und kleiner Bauformen geringer. Das Prinzip der Magnetverstellung kann auch für starke Magnetsysteme mit hohem Materialeinsatz von Rückschlussplatte und Magneten verwendet werden, da die Bauform des Magnetsystems aufgrund der Segmentierung weniger darauf Einfluss hat.

Hierin wird Bezug genommen unter anderem auf eine Magnetronanordnung mit drehbarem Target. Die hinsichtlich des Aufbaus des Magnetsystems bzw. der Magnetsystemsegmente beschriebenen Aspekte können in Analogie auch für ein Magnetron anderen Typs (z.B. ein Planarmagnetron oder eine Ionenquelle (Lion)) gelten. Bei einem Planarmagnetron kann das Target plattenförmig sein. Bei einer Ionenquelle muss nicht notwendigerweise ein Beschichten eines Substrats erfolgen. Das Magnetsystem eines Planarmagnetrons kann in einer festen Lage bezüglich des plattenförmigen Targets angeordnet und eingerichtet sein.

Als Getriebe kann hierin ein Maschinenelement verstanden werden, welches eingerichtet ist, zwei Bewegungsgrößen und/oder Bewegungstypen ineinander umzuformen, die sich voneinander unterscheiden. Beispielsweise für die zwei Bewegungsgrößen (d.h. Größen einer Bewegung) weisen auf: zwei Bewegungsachsen, zwei Kräfte (z.B. Drehmomente), zwei Geschwindigkeiten (z.B. Drehzahlen). Die zwei Bewegungsachsen können sich beispielsweise in ihrer Richtung voneinander unterscheiden. Die zwei Bewegungstypen können beispielsweise eine lineare Bewegung (auch als Translation bezeichnet) und eine drehende Bewegung (auch als Rotation oder Kreisbewegung bezeichnet) sein. Dazu kann das Getriebe ein oder mehr als ein Umformelement aufweisen, welches das Umformen der zwei Bewegungsgrößen ineinander bewirkt. Beispiele für ein Umformelement weisen auf: ein Zahnrad, ein Hebel, ein Gewinde, eine Gleitkeil oder Ähnliches. Mit anderen Worten kann das Getriebe in einem Beispiel einen Gleitkeil und/oder ein Gewinde (z.B. auf einer Antriebswelle) aufweisen.

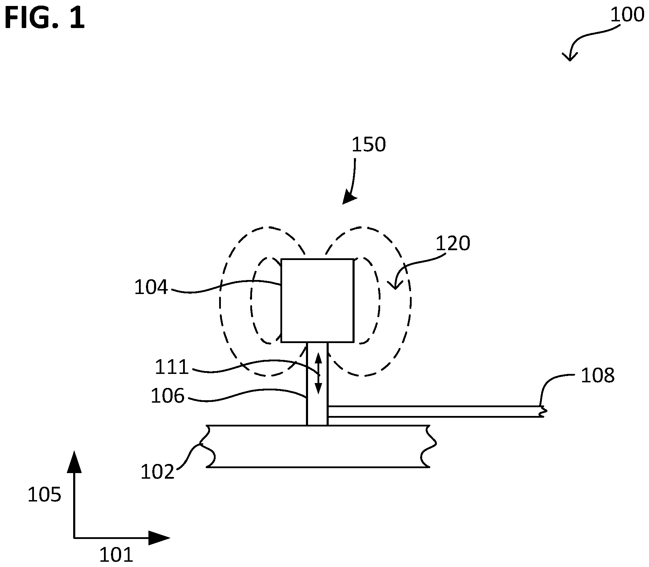

**Fig.1** veranschaulicht eine Magnetronanordnung 100 gemäß verschiedenen Ausführungsformen in einer schematischen Seitenansicht oder Querschnittsansicht.

Die Magnetronanordnung 100 kann einen Träger 102 zum Tragen einer oder mehr als einer Magnetsystemgruppe 150 aufweisen. Der Träger 102 kann ein Rohr, ein Blech, eine Platte, oder Ähnliches aufweisen. Jede Magnetsystemgruppe 150 kann mehrere (z.B. drei oder mehr) Magneten 104 aufweisen. Jeder Magnet 104 einer Magnetsystemgruppe 150 kann beispielsweise eine Magnetisierung aufweisen, z.B. entweder mit einer Richtung (auch als Magnetisierungsrichtung bezeichnet) zu dem Träger hin oder von diesem weg. Zwei der Magneten können sich in ihrer Magnetisierungsrichtung voneinander unterscheiden.

Gemäß verschiedenen Ausführungsformen kann zwischen dem Träger 102 und den Magneten 104 ein Stellglied 106 der Magnetsystemgruppe 150 angeordnet sein, welches den einen oder mehr als einen Magneten 104 mit dem Träger 102 kuppelt.

Das Stellglied 106 kann zum mechanischen Bewegen 111 der Magneten 104 eingerichtet sein (auch als Stellvorgang 111 bezeichnet). Dazu kann das Stellglied 106 mit dem Magneten 104 und dem Träger 102 gekuppelt sein, so dass beim Stellen des Stellglieds 106 eine Lage (d.h. Ausrichtung und/oder Position) des Magneten 104 relativ zu dem Träger 102 verändert werden kann, z.B. gemäß einem Soll-Zustand.

Zum Erzeugen der Bewegung kann das Stellglied 106 einen elektromechanischen Wandler (z.B. einen Elektromotor oder piezoelektrischen Aktor) aufweisen. Der elektromechanische Wandler kann eingerichtet sein, eine translatorische Bewegung zu erzeugen (z.B. im Fall eines Linear-Elektromotors) oder eine rotatorische Bewegung zu erzeugen (z.B. im Fall eines Rotation-Elektromotors).

Zum Übertragen der Bewegung an die Magneten 104 kann das Stellglied 106 optional ein Getriebe (auch als Stellgetriebe bezeichnet) aufweisen.

Das Stellgetriebe kann beispielsweise eingerichtet sein, die rotatorische Bewegung (auch als Drehbewegung bezeichnet) des Elektromotors in eine translatorische Bewegung (auch als Translationsbewegung bezeichnet) umzuwandeln. Dazu kann das Stellgetriebe beispielsweise ein Schraubgetriebe aufweisen oder daraus gebildet sein.

Alternativ oder zusätzlich kann das Stellgetriebe eingerichtet sein, die Bewegung (z.B. translatorische und/oder rotatorische Bewegung) zu übersetzen. Dazu kann das Stellgetriebe ein Rotationsgetriebe bzw. ein Translationsgetriebe aufweisen.

Beispielsweise kann ein Translationsgetriebe eingerichtet sein, eine Translationsbewegung über eine erste Strecke in eine Translationsbewegung über eine zweite Strecke, die (z.B. zweimal, dreimal, viermal, usw.) größer ist als die erste Strecke (gemäß dem Übersetzungsverhältnis des Stellgetriebes), zu überführen oder andersherum. In Analogie kann ein Rotationsgetriebe eingerichtet sein, eine Rotationsbewegung einer ersten Drehzahl in eine Rotationsbewegung einer zweiten Drehzahl, die (z.B. zweimal, dreimal, viermal, usw.) größer ist als die erste Drehzahl (gemäß dem Übersetzungsverhältnis des Stellgetriebes) ist, zu überführen oder andersherum. Das Verhältnis der Strecken bzw. der Drehzahlen wird als Übersetzungsverhältnis bezeichnet.

Das Translationsgetriebe kann beispielsweise ein Scherengetriebe aufweisen oder daraus gebildet sein. Das Scherengetriebe ist vom Typ der Kniehebelgetriebe. Es kann auch ein anderes Kniehebelgetriebe verwendet werden. Der Kniehebel besteht aus mindestens zwei miteinander gelenkig verbundenen Hebelelementen. Beim Scherengetriebe überkreuzen sich die Hebelelemente x-förmig und bilden so ein Scherenglied. Das Kniehebelgetriebe stellt ein wenig komplexes und robustes Getriebe bereit, welches ein großes Übersetzungsverhältnis erreicht. Das Scherengetriebe kann optional mehrere Scherenglieder aufweisen, zum Beispiel mindestens zwei, z.B. drei oder mehr, z.B. vier oder mehr, z.B. fünf oder mehr. Je mehr Scherenglieder das Scherengetriebe aufweist, desto größer kann dessen Übersetzungsverhältnis sein.

Das Scherengetriebe ist ferner weniger empfindlich gegen Abweichung vom Soll-Zustand, da es weniger zum Kippeln neigt.

Beispielsweise kann das Stellgetriebe auch weggelassen werden, wenn ein elektromechanischer Wandler verwendet wird, der eine ausreichend große Bewegung erzeugt.

Zum Versorgen des Stellglieds 106 mit elektrischer Leistung (auch als Versorgungsleistung bezeichnet) und/oder zum Zuführen eines Steuersignals zu dem Stellglied 106 kann das Stellglied 106 mit einer oder mehr als einer elektrischen Leitung 108 gekoppelt sein. Grundsätzlich können das Steuersignal und die Versorgungsleistung gemeinsam über eine Leitung 108 zugeführt werden. Diese können aber auch über voneinander separierte Leitungen 108 zugeführt werden.

Die Versorgungsleistung kann bereitgestellt werden, indem eine sogenannte Versorgungsspannung bereitgestellt wird, welche an dem Stellglied 106 anliegt (an dessen Versorgungseingang). Je mehr Versorgungsleistung das Stellglied 106 pro Zeit aufnimmt, desto größer kann die dem Stellglied 106 zugeführt elektrische Leistung sein (auch als Versorgungsleistung bezeichnet).

Funktionell wird zwischen dem Steuersignal und der Versorgungsleistung (bzw. der Versorgungsspannung) unterschieden. Die Versorgungsspannung kann beispielsweise dauerhaft an dem Stellglied 106 anliegen, ohne einen Stellvorgang 111 und/oder die Aufnahme des Steuersignals zu bewirken. Erst das Zuführen des Steuersignals bewirkt, dass von dem Stellglied 106 Versorgungsleistung aufgenommen wird und in eine Bewegung 111 der Magneten 104 umgesetzt wird. Mit anderen Worten kann zwar auch das Steuersignal eine elektrische Leistung zuführen, allerdings weniger, als in die Bewegung 111 der Magneten 104 umgesetzt wird. Demgegenüber kann die Versorgungsleistung größer sein als in die Bewegung 111 der Magneten 104 umgesetzt wird.

Die Magnetronanordnung 100 kann beispielsweise mehrere Magnetsystemgruppen 150 aufweisen, z.B. pro Träger 102. Beispielsweise kann die Magnetronanordnung 100 (z.B. pro Träger 102) 5 Magnetsystemgruppen 150 aufweisen oder mehr, z.B. 10 Magnetsystemgruppen 150 aufweisen oder mehr, z.B. 15 Magnetsystemgruppen 150 aufweisen oder mehr, z.B. 20 Magnetsystemgruppen 150 aufweisen oder mehr, z.B. 30 Magnetsystemgruppen 150 aufweisen oder mehr, z.B. 40 Magnetsystemgruppen 150 aufweisen oder mehr. Je mehr Magnetsystemgruppen 150 vorliegen, desto präziser kann das Magnetfeld gestellt werden.

Die oder jede Magnetsystemgruppe 150 kann beispielsweise mehrere Magneten 104 aufweisen, z.B. pro Stellglied 106. Beispielsweise kann die Magnetsystemgruppe 150 (z.B. pro Stellglied 106) maximal drei Magneten 104 aufweisen oder mehr, z.B. maximal sechs Magneten 104 oder mehr, z.B. maximal 9 Magneten 104 oder mehr, z.B. maximal 12 Magneten 104 oder mehr, z.B. maximal 15 Magneten 104 oder mehr, z.B. maximal 21 Magneten 104 oder mehr, z.B. maximal 30 Magneten 104 oder mehr. Je weniger Magneten pro Stellglied 106 vorliegen, umso feingliedriger kann das Magnetfeld gestellt werden. Je mehr Magneten pro Stellglied 106 vorliegen umso weniger komplex ist die Ansteuerung.

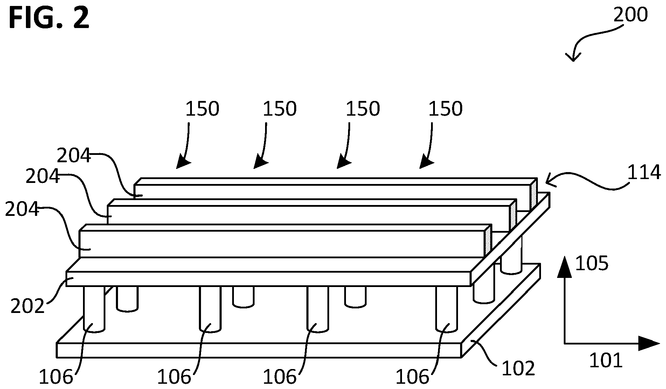

**Fig.2** veranschaulicht die Magnetronanordnung 100 gemäß verschiedenen Ausführungsformen 200 in einer schematischen Perspektivansicht. Die Magnetronanordnung 100 kann ein Magnetsystem 114 aufweisen, welches vom dem Träger 102 gehalten wird.

Das Magnetsystem 114 kann gemäß verschiedenen Ausführungsformen mehrere, z.B. drei reihenförmig angeordnete und räumlich voneinander separierte Magnetreihen 204 aufweisen, die auf einem gemeinsamen Magnetträger 202 befestigt sind. Jede der Magnetreihen 204 kann mehrere nebeneinander angeordnete Magnete einer Magnetisierungsrichtung aufweisen. Die Magnete können derart angeordnet und ausgerichtet sein, dass die nebeneinander angeordneten Magnetreihen 204 zueinander entgegengesetzte Magnetisierungsrichtungen aufweisen. Beispielsweise können die äußeren beiden Magnetreihen 204 von dem Träger 102 weg magnetisiert sein, wobei die mittig angeordnete Magnetreihe 204 zu dem Träger 102 hin magnetisiert sein kann (oder andersherum).

Beispielsweise können die Magnete des Magnetsystems 114 magnetisch an dem Magnetträger 202 befestigt sein, wobei der Magnetträger 202 beispielsweise ein magnetisierbares Material aufweisen kann (z.B. Eisen).

Jede der Magnetsystemgruppen 150 kann ein Segment (auch als Rückschlussplatte bezeichnet) des Magnetträgers 202 aufweisen, und einen oder mehr als einen Magneten pro Magnetreihe 204.

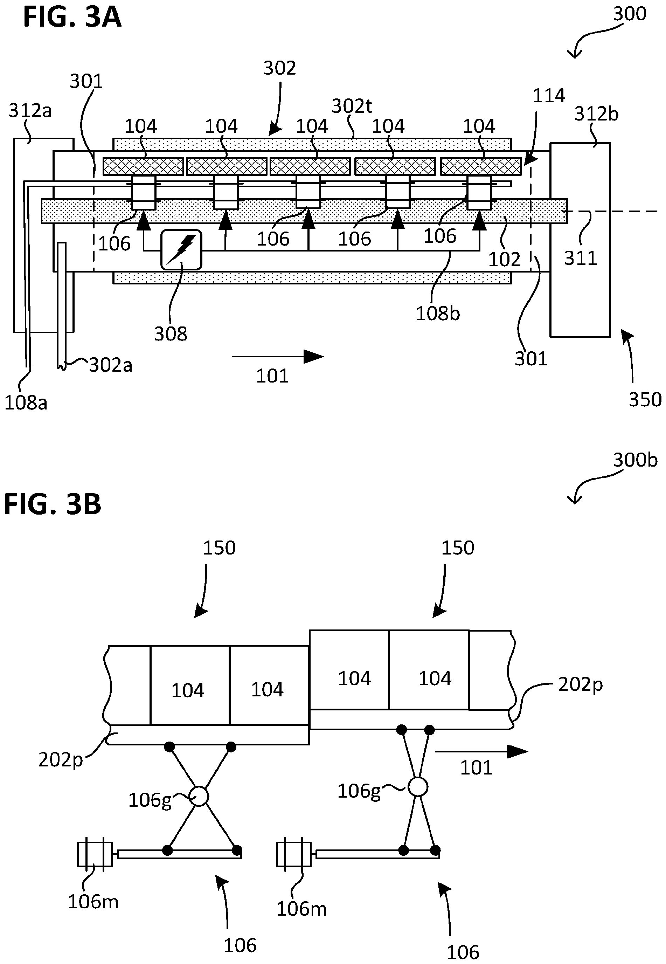

**Fig.3A** veranschaulicht die Magnetronanordnung 100 gemäß verschiedenen Ausführungsformen 300 in einer schematischen Seitenansicht oder Querschnittsansicht und **Fig.3B** in einer schematischen Detailansicht 300b.

Die Magnetronanordnung 100 kann eine Lageranordnung 350 aufweisen zum drehbaren Lagern eines rohrförmigen Targets 302 (auch als Rohrtarget bezeichnet). Die Lageranordnung 350 kann zwei Endblöcke 312a, 312b aufweisen, wobei das Rohrtarget 302 mittels der Endblöcke 312a, 312b drehbar gelagert sein kann. Dazu können die Endblöcke 312a, 312b entsprechende Drehlager aufweisen. Mittels der Drehlager kann beispielsweise eine Kupplungsvorrichtung drehbar gelagert sein, mit welcher das Rohrtarget 302 gekuppelt werden kann.

Beispielsweise kann ein Innendurchmesser (Ausdehnung des innenliegenden Hohlraums quer zur Drehachse) des Rohrtargets 302 in einem Bereich sein von ungefähr 100 mm bis ungefähr 150 mm, beispielsweise ungefähr 125 mm (Millimeter).

Der erste Endblock 312a der zwei Endblöcke 312a, 312b kann als Antriebsendblock 312a eingerichtet sein, d.h. einen Antriebsstrang 302a zum Drehen des Rohrtargets 302 aufweisen. Der zweite Endblock 312b der zwei Endblöcke kann als Medienendblock 312b eingerichtet sein, d.h. zum Zuführen und Abführen eines Kühlfluids (z.B. Wasser aufweisend) und/oder zum Versorgen des Rohrtargets 302 mit elektrischer Leistung. Das Kühlfluid kann durch das Rohrtarget 302 hindurch geleitet werden.

Der Antriebsstrang 302a kann mit einer außerhalb des Antriebsendblocks 312a angeordneten Antriebsvorrichtung (z.B. einem Motor) gekuppelt sein oder diesen aufweisen. Mittels des Antriebsstrangs 302a kann ein Drehmoment in das Rohrtarget 302 eingekuppelt werden zum Antreiben einer Drehbewegung des Rohrtargets 302.

Generell kann das Rohrtarget 302 ein Targetmaterial 302t aufweisen oder daraus gebildet sein. Optional kann das Rohrtarget 302 ein Rohr aufweisen, auf welchem das Targetmaterial 302t befestigt ist.

Ferner kann die Magnetronanordnung 100 als Träger 102 ein Trägerrohr 102 aufweisen, welches mittels der zwei Endblöcke 312a, 312b gehalten wird, z.B. ortsfest und/oder drehgesichert. Beispielsweise kann das Trägerrohr 102 beim Drehen des Rohrtargets 302 (um das Trägerrohr 102 herum) in einer festen Ausrichtung bezüglich der Endblöcke 312a, 312b verbleiben.

Beispielsweise kann das Rohrtarget 302 um eine Rotationsachse 311 (parallel zur Richtung 101) der Magnetronanordnung 100 drehbar gelagert sein, wobei die Rotationsachse 311 parallel zu einer Längserstreckung des Trägerrohrs 102 verlaufen und optional innerhalb des Trägerrohrs 102 angeordnet sein kann.

Jeder der Endblöcke 312a, 312b kann eine Targetkupplung 301 aufweisen mittels welcher das Rohrtarget 302 angekuppelt werden kann, z.B. an den Antriebsstrang 302a und/oder an die Kühlfluidversorgung (z.B. eine oder mehr als eine Fluidleitung aufweisend). Beispielsweise kann die Targetkupplung 301 eine lösbare Verbindung aufweisen, die ein Montieren und Demontieren des Rohrtargets 302 ermöglicht kann.

Ferner kann die Magnetronanordnung 100 einen elektrischen Generator 308 aufweisen, welcher eingerichtet ist, jedem der Stellglieder 106 elektrische Leistung zuzuführen. Dazu kann die Leitung 108 eine elektrische Versorgungsleitung 108b aufweisen, welche den Generator 308 mit jedem der Stellglieder 106 koppelt.

Ferner kann die Leitung 108 eine Steuerleitung 108a aufweisen, welche in einen der Endblöcke hinein verläuft. Beispielsweise kann die Steuerleitung 108a einen entsprechenden Anschluss an dem Endblock aufweisen, mittels dessen der Steuerleitung 108a von außerhalb des entsprechenden Endblocks 312a, 312b das Steuersignal eingekoppelt werden kann.

In Detailansicht 300b sind exemplarisch zwei Magnetsystemgruppen 150 dargestellt, von denen jede Magnetsystemgruppe eine Rückschlussplatte 202p aufweist; mehrere Magneten 104 aufweist, welche mittels der Rückschlussplatte 202p magnetisch miteinander gekoppelt sind; und genau ein elektrisches Stellglied 106 aufweist, welches eingerichtet ist, die Lage der Rückschlussplatte 202p bzw. der Magneten 104 relativ zu dem Trägerrohr 102 zu stellen in Antwort auf das dem Stellglied 106 zugeführte elektrische Steuersignal.

Das Stellglied 106 weist ein Getriebe 106g auf, welches den Motor 106m mit der Rückschlussplatte 202p kuppelt. Eine von dem Motor 106m erzeugte Bewegung kann mittels des Getriebes 106g in eine Translationsbewegung überführt werden, die auf die Rückschlussplatte 202p übertragen wird.

Wie dargestellt ist, können die Stellglieder 106 unabhängig voneinander angesteuert werden.

Der Motor 106m kann optional ein Schrittmotor sein. Dies erhöht die Genauigkeit. Alternativ oder zusätzlich zu einem Rotationsmotor als Motor 106m kann auch ein piezoelektrischer Aktor oder ein anderer Linear-Motor verwendet werden.

Beispielsweise kann das Stellglied 106 einen Schrittmotor 106m mit einer direkt getriebenen Achse und selbsthemmendem Gewinde als Getriebe aufweisen oder daraus gebildet sein. Dies ist eine besonders kostengünstige Lösung hoher Genauigkeit.

Beispielsweise kann mittels des Stellglieds 106 ein Abstand der Rückschlussplatte 202p von dem Träger 102 verändert werden, z.B. gemäß einem Soll-Zustand.

Das Getriebe 106g kann optional eine oder mehr als eine Getriebestufe aufweisen, welche je nach Bedarf verschiedene Funktionen erfüllen können. Zumindest eine Getriebestufe kann eingerichtet sein, die Drehbewegung des Motors in eine Translation überführen (auch als Überführungsgetriebe bezeichnet), z.B. mittels eines Schneckengewindes. Alternativ oder zusätzlich kann zumindest eine Getriebestufe ein Übersetzungsverhältnis verschieden von 1 aufweisen (auch als Übersetzungsgetriebe bezeichnet). Das exemplarisch abgebildete Getriebe 106g weist ein Scherengetriebe als Übersetzungsgetriebe auf. Nachfolgend wird exemplarisch ein Gleitkeil 106k als Übersetzungsgetriebe erläutert.

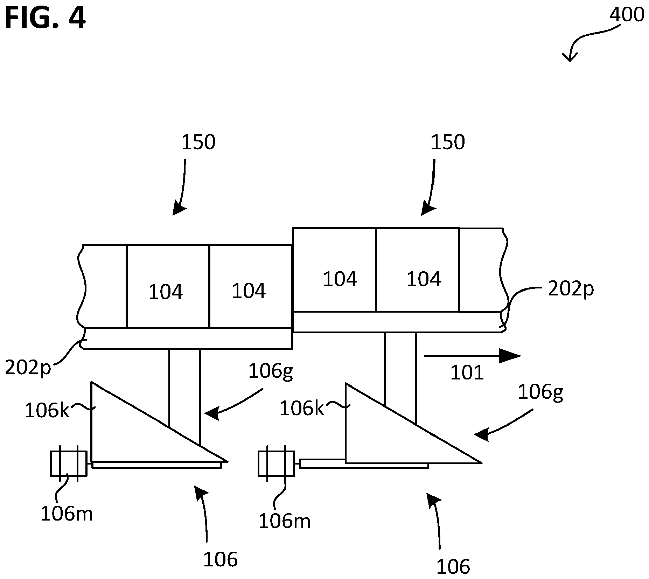

**Fig.4** veranschaulicht die Magnetronanordnung 100 gemäß verschiedenen Ausführungsformen 400 in einer schematischen Seitenansicht oder Querschnittsansicht.

Das Getriebe 106g des Stellglieds 106 weist gemäß den Ausführungsformen 400 einen Gleitkeil 106k auf, welcher den Motor 106m mit der Rückschlussplatte 202p kuppelt. Eine von dem Motor 106m erzeugt Bewegung kann in eine Translationsbewegung des Gleitkeils 106k überführt werden und mittels des Gleitkeils 106k auf die Rückschlussplatte 202p übertragen werden.

Der Gleitkeil 106k erreicht eine selbsthemmende Wirkung des Stellglieds 106. Mit anderen Worten muss das Stellglied 106 dann nicht notwendigerweise Leistung benötigen, um den Ist-Zustand aufrecht zu erhalten. Einmal verstellt, bleibt der Ist-Zustand des Stellglieds 106 somit unverändert. Dies verringert den Energieverbrauch.

Die selbsthemmende Wirkung kann selbstverständlich auch anders erreicht werden, beispielsweise mittels eines Kugelgewindetriebs oder Ähnlichem. Allgemeiner gesprochen kann das Stellglied 106 selbsthemmend eingerichtet sein.

Ein selbsthemmendes Stellglied 106 kann beispielsweise eine oder mehr als ein selbsthemmendes Getriebe aufweisen. Das selbsthemmende Getriebe kann beispielsweise ein Übersetzungsverhältnis kleiner ist als ungefähr 10% aufweisen, z.B. kleiner als ungefähr 5%, z.B. kleiner als ungefähr 2%, z.B. kleiner als ungefähr 1%. Je kleiner das Übersetzungsverhältnis, desto besser die selbsthemmende Wirkung. Alternativ oder zusätzlich kann das selbsthemmende Getriebe einen Haftreibzahl µ aufweisen, welche folgende Relation erfüllt: 0,5·α<arctan(µ), wobei α den Winkel bezeichnet, welchen die Bewegungsrichtung des Getriebes und die abgleitende Fläche miteinander einschließen.

Das Stellglied 106, z.B. dessen Getriebe 106g, kann optional derart eingerichtet sein, dass als rücktreibende Kraft die Gewichtskraft der Magneten 104 bzw. Rückschlussplatte ausreicht. Dies reduziert den Energiebedarf weiter.

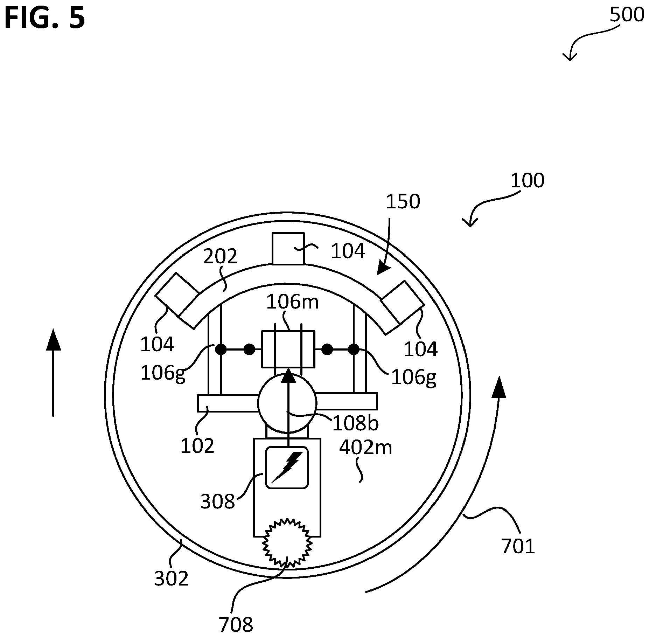

**Fig.5** veranschaulicht die Magnetronanordnung 100 gemäß verschiedenen Ausführungsformen 500 in einer schematischen Seitenansicht oder Querschnittsansicht (mit Blick entlang der Drehachse 311).

Der Generator 308 kann innerhalb des Rohrtargets 302 (wenn vorhanden) angeordnet sein. Allgemeiner gesprochen, kann der Generator 308 innerhalb eines Kreiszylinders als Einhüllende angeordnet sein, der an die Magneten 104 angrenzt und dessen Zylinderachse die Drehachse 311 ist.

Der Generator 308 kann ein Antriebsrad 708 aufweisen, welches in Kontakt mit dem Rohrtarget 302 ist oder gebracht werden kann. Wird das Rohrtarget 302 in Drehung versetzt, kann die Drehbewegung des Rohrtargets 302 mittels des Antriebsrads 708 dem Generator 308 eingekoppelt werden. Das Antriebsrad 708 kann mit einem Rotor des Generators 308 (auch als Generatorrotor bezeichnet) gekuppelt sein, so dass die eingekoppelte Drehbewegung auf den Generatorrotor übertragen wird.

Der Generator 308 kann ferner einen Stator (auch als Generatorstator bezeichnet) aufweisen, welcher ortsfest bezüglich des Trägers 102 angeordnet ist. Wird der Generatorrotor in Drehbewegung relativ zu dem Generatorstator versetzt, kann der Generator die Versorgungsspannung bereitstellen. Beispielsweise können der Generatorstator 308s und/oder der Generatorrotor neben dem Träger 102 angeordnet sein.

Der Generatorstator oder der Generatorrotor können eine Vielzahl von Spulen aufweisen, welche die Versorgungsspannung erzeugen (mittels Induktion). Der jeweils andere des Generatorstators oder Generatorrotors kann eine Vielzahl Magneten aufweisen, welche die Induktion anregen.

Optional kann der Generator 308 ein Getriebe (auch als Generatorgetriebe bezeichnet) aufweisen, welches das Antriebsrad 708 aufweist. Das Generatorgetriebe kann eingerichtet sein, dem Generatorrotor eine größere Drehzahl bereitzustellen als dem Antriebsrad 708 eingekoppelt wird.

Beispielsweise kann das Generatorgetriebe ein Planetengetriebe aufweisen oder daraus gebildet sein. Dieses ist besonders kompakt und zuverlässig. Das Planetengetriebe kann beispielsweise mehrstufig (d.h. mehrere Getriebestufen aufweisen) sein, z.B. dreistufig oder mehr.

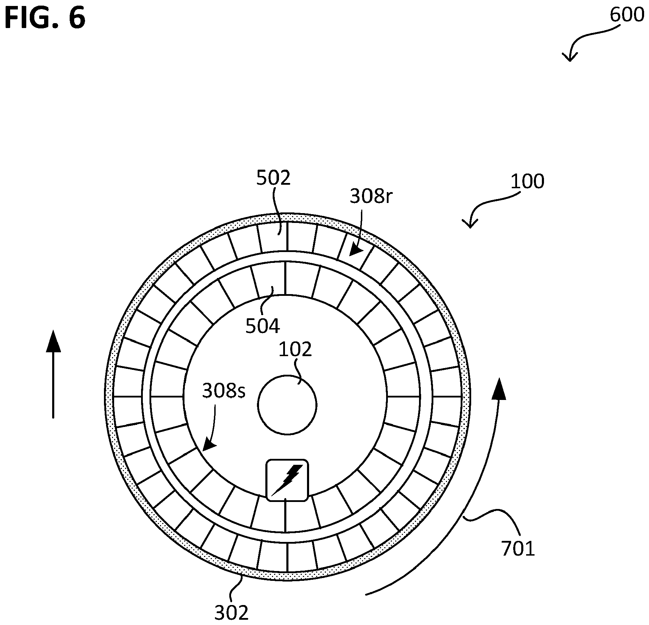

**Fig.6** veranschaulicht die Magnetronanordnung 100 gemäß verschiedenen Ausführungsformen 600 in einer schematischen Seitenansicht oder Querschnittsansicht (mit Blick entlang der Drehachse 311).

Der Generatorstator 308s und/oder der Generatorrotor 308r können den Träger 102 umgeben. Der Generatorrotor 308r kann an dem Rohrtarget 302 befestigt oder in diesem integriert sein, so dass dessen Drehzahl der Drehzahl des Rohrtargets 302 (auch als Targetdrehzahl bezeichnet) entspricht.

Diese Konfiguration ermöglicht einen Generator mit einer höheren Polzahl, was die Versorgungsspannung vergrößert und damit die von dem Generator erzeugbare Versorgungsleistung bei der Nenndrehzahl des Targets (auch als Targetdrehzahl bezeichnet). Eine hohe Poldichte (Wechselpoldichte) kompensiert anschaulich eine langsame Drehbewegung des Rohrtargets 302.

Beispielsweise kann der Generatorrotor 308r eine Vielzahl von Magneten 502 (auch als Generatormagneten bezeichnet) aufweisen, welche an der Innenwand des Rohrtargets 302 befestigt sind. Alternativ können die Generatormagneten 502 auch an einem Deckel (auch als Targetdeckel bezeichnet) für das Rohrtarget 302 befestigt sein. Der Targetdeckel kann beispielsweise den das Rohrtarget 302 durchdringenden Hohlraum abdecken.

Beispielsweise kann der Generatorstator 308s eine Vielzahl von Spulen 504 (auch als Generatorspulen bezeichnet) aufweisen, welche mittels des Trägers 102 gestützt werden und/oder diesen zumindest umgeben.

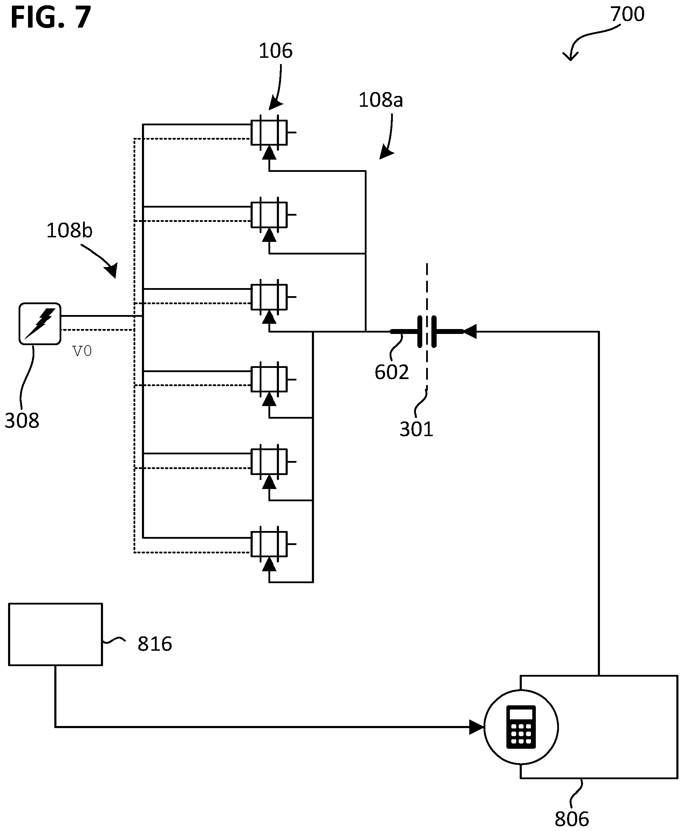

**Fig.7** veranschaulicht die Magnetronanordnung 100 gemäß verschiedenen Ausführungsformen 700 in einem schematischen Verschaltungsdiagramm. Hier sind exemplarisch 6 Stellglieder 106 veranschaulicht, wobei deren Anzahl auch größer oder kleiner sein kann. Ferner kann die Magnetronanordnung 100 eine Steuervorrichtung 806 aufweisen, welche das Steuersignal erzeugt.

Es kann verstanden werden, dass mittels des Steuersignals eine Kommunikation zwischen der Steuervorrichtung 806 und einem Stellglied 106 erfolgen kann, z.B. bidirektional. Mit anderen Worten kann das Steuersignal der Träger einer Informationsübertragung zwischen der Steuervorrichtung 806 und einem Stellglied 106 sein. Optional kann mittels des Steuersignals eine Kommunikation zwischen der Steuervorrichtung 806 und dem Generator erfolgen, z.B. um dessen Arbeitspunkt zu steuern und/oder zu regeln.

Das Steuersignal kann anschaulich ein elektrisches Signal sein, mittels dessen Informationen übertragen werden können, beispielsweise Instruktionen, Anfragen und/oder Antworten. Die Kommunikation mittels des Steuersignals kann, auf physischer Ebene, mittels eines Austausches elektrischer Leistung erfolgen. Die physische Ebene der Kommunikation kann mittels physischer Transmitter erfolgen. Die Kommunikation mittels des Steuersignals kann, auf logischer Ebene, mittels eines Austauschs an Informationen erfolgen. Die logische Ebene der Kommunikation kann mittels einer Datenverarbeitung erfolgen, welche beispielsweise mittels eines Prozessors und/oder eines Programms implementiert werden kann und/oder die Transmitter ansteuert. Der Austausch elektrischer Leistung kann beispielsweise gemäß der zu übertragenden Information moduliert sein oder werden.

Die Kommunikation kann beispielsweise nachrichtenbasiert (d.h. auf Grundlage von Nachrichten) gemäß einem Kommunikationsprotokoll (z.B. einem Netzwerkprotokoll) erfolgen. Beispielsweise kann ein Feldbus-Netzwerkprotokoll als Kommunikationsprotokoll verwendet werden. Beispielsweise kann ein USB-Bus-Netzwerkprotokoll als Kommunikationsprotokoll verwendet werden (Universeller serieller Bus - USB). Selbstverständlich kann auch ein anderes Kommunikationsprotokoll verwendet werden, welches beispielsweise proprietär sein kann.

Eine Nachricht kann beispielsweise das Stellglied 106 adressieren, an welche die Nachricht gerichtet ist (d.h. dessen Adresse aufweisen). Ferner kann die Nachricht die zu übertragende Information aufweisen.

Die Kommunikation kann beispielsweise unidirektional (d.h. nur von der Steuervorrichtung zu dem Stellglied 106) sein oder bidirektional sein (d.h. hin und zurück). Die bidirektionale Kommunikation kann das Ansteuern von der Steuervorrichtung 806 zu dem Stellglied 106 (auch als hinführender Kommunikationskanal bezeichnet) und eine Rückmeldung von dem Stellglied 106 zu der Steuervorrichtung 806 (auch als rückführender Kommunikationskanal bezeichnet) aufweisen. Allgemeiner gesprochen kann die Steuerleitung 108a einen oder mehr als einen Kommunikationskanal bereitstellen.

Eine von der Steuervorrichtung 806 an das Stellglied 106 übertragene Information kann beispielsweise den Soll-Zustand repräsentieren, den das Stellglied 106 einnehmen soll. Eine von einem Stellglied 106 an die Steuervorrichtung 806 übertragene Information kann beispielsweise den Ist-Zustand des Stellglieds 106 repräsentieren oder eine Empfangsbestätigung.

Die Steuerleitung 108a kann optional eine Kommunikationsschnittstelle 602 an der Targetkupplung 301 aufweisen. Die Kommunikationsschnittstelle 602 kann eingerichtet sein, das Steuersignal zwischen der Steuervorrichtung 806 und einem oder mehr als einem der Stellglieder 106 auszutauschen. Mit anderen Worten kann die Kommunikationsschnittstelle 602 eingerichtet sein, das Steuersignal weiterzugeben, z.B. bidirektional. Dies kann mittels einer optischen Kopplung, induktiven Kopplung und/oder kapazitiven Kopplung erfolgen. Diese erreichen eine zuverlässigere Kommunikation. Anschaulich kann eine optische, induktive und/oder kapazitive Weitergabe des Steuersignals eine galvanische Trennung zwischen Stellglied 106 und Steuervorrichtung 806 bewirken. Diese galvanische Trennung hemmt elektrische Störeinflüsse im Betrieb der Steuervorrichtung 806, welche ihre Ursache beispielsweise in der Drehbewegung des Rohrtargets 302, der Leistungsversorgung des Plasmas über das Rohrtarget 302 und/oder der Plasmabildung selbst haben können.

Grundsätzlich kann die Signalweitergabe auch ohmsch erfolgen, d.h. dass die Steuervorrichtung als Signalquelle und das Stellglied 106 als Signalempfänger ohmsch miteinander gekoppelt sind.

Optional kann die Kommunikationsschnittstelle 602 derart eingerichtet sein, dass der eine oder mehr als eine Kommunikationskanal im Takt der Drehbewegung des Rohrtargets unterbrochen (d.h. geöffnet) und hergestellt (d.h. geschlossen) wird, z.B. abwechselnd unterbrochen und hergestellt wird. Dies bewirkt, dass die Kommunikation gemäß der Drehbewegung des Targets getaktet erfolgt (d.h. im Takt der Drehbewegung).

Beispielsweise können zwei Kommunikationskanäle abwechselnd (d.h. im Gegentakt zueinander) hergestellt bzw. unterbrochen werden. Alternativ oder zusätzlich kann ein Kommunikationskanal abwechselnd hergestellt und unterbrochen werden.

Beispielsweise kann die Kommunikationsschnittstelle 602 als drehwinkelabhängiger Schalter eingerichtet sein, welcher geöffnet ist, wenn das Rohrtarget in einer ersten Position bzw. einem ersten Drehwinkelbereich ist, und welcher geschlossen ist, wenn das Rohrtarget in einer zweiten Position bzw. einem zweiten Drehwinkelbereich ist.

Diese Taktung erreicht eine zuverlässigere Kommunikation. Anschaulich können so Störeinflüsse, die ihren Ursprung in der Drehbewegung des Rohrtargets 302 haben, systematisch sein, was es erleichtert, diese herauszufiltern.

Es kann verstanden werden, dass diese getaktete Kommunikation auf der physischen Ebene der Kommunikation und/oder auf der logischen Ebene der Kommunikation implementiert werden kann. Beispielsweise kann die ohmsche, optische, induktive und/oder kapazitive Kopplung physisch im Takt der Drehbewegung des Rohrtargets unterbrochen (d.h. geöffnet) und wiederhergestellt (d.h. geschlossen) werden, z.B. abwechselnd. Alternativ oder zusätzlich kann die logische Kommunikation (z.B. das Senden und/oder Empfangen von Daten oder ganzen Nachrichten) getaktet sein, so dass dieses unterbrochen und wiederhergestellt wird.

Der Generator 308 kann eingerichtet sein, im Betrieb (beispielsweise bei der Targetdrehzahl) des Rohrtargets 302, eine Leerlaufspannung V0 als Versorgungsspannung zu erzeugen. Diese Leerlaufspannung V0 kann an allen Stellgliedern 106 anliegen oder mittels eines Multiplexers individuell an immer nur einem der Stellglieder 106 angelegt sein, welches angesteuert wird.

Wird eines der Stellglieder 106 angesteuert, kann das Stellglied 106 entsprechend elektrische Leistung aufnehmen, welche zum Verstellen des Magnetfeldes aufgebracht wird. Dabei kann die Versorgungsspannung von der Leerlaufspannung V0 auf die Nennspannung Vn absinken. Das System aus Generator als Leistungserzeuger und Stellglied als Leistungsverbraucher nimmt dabei einen festen Arbeitspunkt ein, welcher als freien Parameter lediglich die Targetdrehzahl aufweist. Die Targetdrehzahl kann für die Leistungsbilanz in erster Näherung als konstant angesehen werden und/oder im Wesentlichen der Nenndrehzahl des Generators 308 entsprechen.

Gemäß der Nennspannung Vn und der Targetdrehzahl kann der Generator 308 eine dazu korrespondierende elektrische Leistung (auch als Generator-Nennleistung bezeichnet) bei der Nennspannung Vn erzeugen, welche von dem Stellglied 106 aufgenommen wird.

Der Generator 806 kann derart eingerichtet sein, dass die Generator-Nennleistung größer ist als die Leistungsaufnahme genau eines Stellglieds 106, d.h. die aufgenommene Nennleistung pro Stellglied 106 (auch als Verbraucherleistung bezeichnet). Dies erreicht, dass auf einen Energiespeicher verzichtet werden kann, was die Energieversorgung weniger komplex und damit zuverlässiger macht.

Der Generator 806 kann derart eingerichtet sein, dass die Generator-Nennleistung kleiner ist als die summierte Leistungsaufnahme zweier Stellglieder 106. Dies erreicht, dass der Generator möglichst kompakt gebaut werden kann und nicht mehr Leistung erzeugt, als benötigt wird.

Die Verbraucherleistung pro Stellglied 106 kann eine Funktion der Geschwindigkeit sein, mit der das Verstellen des Magnetfeldes erfolgt, und eine Funktion der Masse sein, die zum Verstellen des Magnetfeldes (auch als Verstellvorgang bezeichnet) verlagert wird. Je weniger Magneten pro Stellglied verwendet werden, desto kleiner ist die pro Stellglied zu verlagernde Masse. Dies erreicht, dass der Generator möglichst kompakt gebaut werden kann.

Je mehr Magneten pro Stellglied 106 verwendet werden, desto kleiner ist die Anzahl der Stellglieder 106. Dies erreicht, dass die Magnetronanordnung 100 weniger komplex und damit zuverlässiger ist.

Die Magnetronanordnung 100 kann beispielsweise pro Stellglied 106 eine Anzahl von 3·n oder weniger Magneten 104 aufweisen, wobei n eine natürliche Zahl in dem Bereich sein kann von ungefähr 1 bis ungefähr 10, z.B. in einem Bereich von ungefähr 1 bis ungefähr 5, z.B. in einem Bereich von ungefähr 1 bis ungefähr 3.

Im Folgenden werden exemplarische Kenndaten von Komponenten der Kette der Energieversorgung erläutert, welche einen guten Kompromiss aus Komplexität und Zuverlässigkeit bereitstellen.

Die Generator-Nennleistung kann in einem Bereich von ungefähr 10 Watt bis ungefähr 50 Watt sein.

Die aufgenommene Nennleistung (Verbraucherleistung) pro Stellglied 106 kann in einem Bereich von ungefähr 10 Watt bis ungefähr 50 Watt sein und/oder in einem Bereich von ungefähr der halben Generator-Nennleistung bis ungefähr der Generator-Nennleistung.

Die Nenndrehzahl des Generators bzw. die Targetdrehzahl des Rohrtargets 302 kann in einem Bereich von ungefähr 5 U/min (Umdrehungen pro Minute) bis ungefähr 30 U/min sein.

Die pro Stellglied 106 zu verlagernde Masse der Magnetsystemgruppe 150 kann in einem Bereich von ungefähr 100 g (Gramm) bis ungefähr 500 g sein.

Das oder jedes Stellglied 106 kann eingerichtet sein, den Stellbereich (d.h. den Bereich, in dem) abzufahren in einer Zeit von ungefähr 1 s (Sekunde), z.B. in einem Bereich von ungefähr 0,5 s bis ungefähr 5 s. Dies erreicht eine ausreichend kurze Reaktionszeit für das Verstellen des Magnetfeldes. Der Stellbereich bezeichnet den Bereich, der von den am stärksten voneinander verschiedenen möglichen Ist-Zuständen, welche das Stellglied 106 einnehmen kann, aufgespannt wird.

Die Magnetronanordnung 100 kann ferner einen oder mehr als einen Sensor 816 aufweisen, welcher eingerichtet ist, den Ist-Zustand (auch als Prozesszustand bezeichnet) eines mittels der Magnetronanordnung 100 bereitgestellten Sputterprozesses (z.B. Beschichtungsprozesses) und/oder des Magnetfeldes zu erfassen. Die Steuervorrichtung 806 kann eingerichtet sein, die Stellglieder 106 auf Grundlage des Prozesszustands anzusteuern. Beispielsweise kann das Ansteuern der Stellglieder 106 auf Grundlage eines vorgegebenen Soll-Zustands erfolgen, z.B. derart, dass eine Differenz zwischen dem Prozesszustand und dem Soll-Zustand verringert wird.

Ein Sensor kann Teil einer Messkette sein, welche eine entsprechende Infrastruktur (z.B. Prozessor, Speichermedium und/oder Bussystem oder dergleichen aufweisend) aufweist. Die Messkette kann eingerichtet sein, den entsprechenden Sensor anzusteuern, dessen erfasste Messgröße als Eingangsgröße zu verarbeiten und darauf basierend ein elektrisches Signal als Ausgangsgröße bereitzustellen, welches den Ist-Zustand der Eingangsgröße zum Zeitpunkt des Erfassens repräsentiert. Die Messkette kann beispielsweise mittels der Steuervorrichtung 806 (z.B. einer speicherprogrammierbaren Steuervorrichtung - SPS) implementiert sein oder werden.

Jeder Sensor 816 kann eingerichtet sein, eine oder mehr als eine Messgröße zu erfassen als Repräsentant des Prozesszustands. Die Messgröße kann beispielsweise eine elektrische, magnetische oder optische Messgröße sein. Alternativ oder zusätzlich können mehrere Sensoren 816 verwendet werden, um den Prozesszustand zu erfassen.

Ist ein oder mehr als ein Sensor 816 innerhalb des Rohrtargets 302 angeordnet, kann diesem optional ein eigener Kommunikationskanal mittels der Steuerleitung 108a bereitgestellt sein oder werden.

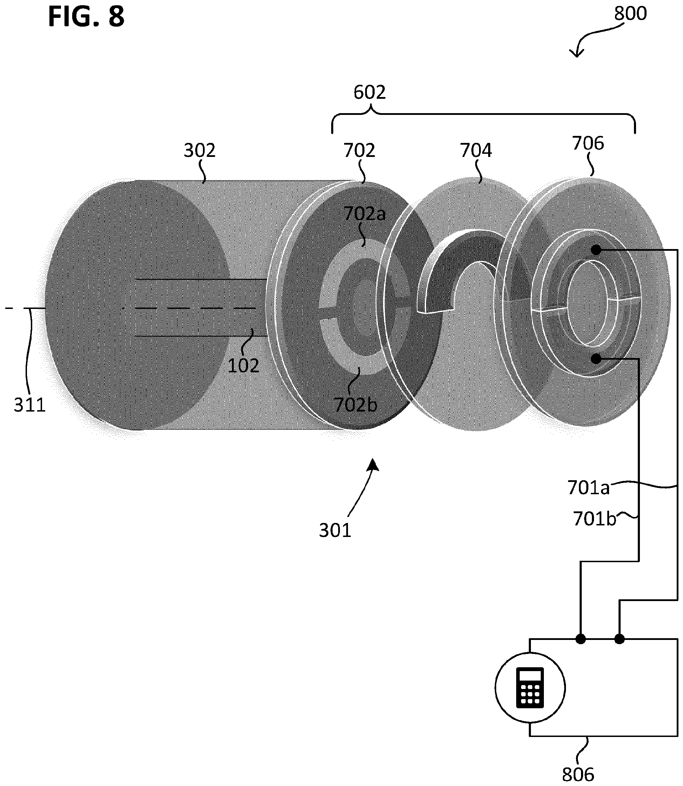

**Fig.8** veranschaulicht die Magnetronanordnung 100 gemäß verschiedenen Ausführungsformen 800 in einer schematischen perspektivischen Detailansicht (mit Blick auf die Drehachse 311) auf die Targetkupplung 301. Im Folgenden wird eine exemplarische Implementierung der getakteten Kommunikation auf physischer Ebene erläutert. Es kann verstanden werden, dass die Aspekte der exemplarischen Implementierung auf physischer Ebene in Analogie auch für eine Implementierung auf logischer Ebene gelten kann.

Hier ist exemplarisch eine Steuerleitung 108a mit zwei Kommunikationskanälen 701a, 701b veranschaulicht, welche beispielsweise einen hinführenden Kommunikationskanal 701a und einen rückführenden Kommunikationskanal 701b aufweisen können. Der hinführende Kommunikationskanal 701a kann beispielsweise mit dem Sender (sendender Teil des Transceivers) der Steuervorrichtung 806 gekoppelt sein. Der rückführende Kommunikationskanal 701b kann beispielsweise mit dem Empfänger (empfangenden Teil des Transceivers) der Steuervorrichtung 806 gekoppelt sein.

Die Kommunikationsschnittstelle 602 kann aufweisen: eine erste Scheibe 702, welche ortsfest relativ zu dem Träger 102 eingerichtet ist; eine Kopplungsblende 704, welche ortsfest relativ zu dem Rohrtarget 302 bzw. (wenn das Rohrtarget 302 noch nicht montiert ist) zu der das Rohrtarget 302 antreibenden Komponente des Antriebsstrangs 302a gelagert ist; und eine zweite Scheibe 706, welche ortsfest relativ zu dem Träger 102 eingerichtet ist.

Die erste Scheibe 702 und die zweite Scheibe 706 können ortsfest zueinander eingerichtet sein. Die erste Scheibe 702 kann beispielsweise mittels des Trägers 102 gehalten werden. Die zweite Scheibe 706 kann beispielsweise mittels eines Endblocks 312a, 312b gehalten werden.

Im Fall einer kapazitiven Kopplung zum Einkoppeln des Steuersignals können die erste Scheibe 702 und die zweite Scheibe 706 jeweils eine oder mehr als eine (z.B. ringsegment-förmige) Platte 702a, 702b aufweisen, z.B. mehrere Platten in Form von einander fortsetzenden Ringsegmenten (d.h. Segmente eines Rings). Die zwei Platten 702a, 702b können denselben Segmentwinkel aufweisen, z.B. in einem Bereich von ungefähr 140° bis ungefähr 180°.

In ähnlicher Weise kann die Kopplungsblende 704 eine oder mehr als eine (z.B. ringsegment-förmige) Platte aufweisen, welche in ihrer Form zu dem einen oder mehr als einen Ringsegment der ersten Scheibe 702 und der zweiten Scheibe 706 korrespondiert.

Einander gegenüberliegende Platten können jeweils paarweise einen Kondensator bilden. Somit können zwei Kondensatoren bereitgestellt werden, die in Reihe geschaltet sind.

Ein erster Kondensator wird von dem Ringsegment auf der ersten feststehenden Scheibe 706 und einem Ringsegment auf der drehbaren Scheibe 704 gebildet. Die drehbare Scheibe 704 weist beispielsweise Stahl auf und/oder bildet eine Flansch-Dichtung für das Rohrtarget. Auf diese Metallplatte kann eine (z.B. etwa 2 mm dicke) Plastikscheibe montiert sein, welche das entsprechende erste Ringsegment trägt. Das erste Ringsegment bildet mit dem Ringsegment 702a auf der feststehenden Scheibe 706 den ersten Kondensator. Die Plastikscheibe erreicht eine elektrische Isolation und/oder eine Reduktion der parasitären Kapazität gegen den Flanschdeckel, der beispielsweise elektrisch auf Massepotential liegen kann. Dazu kann die Plastikscheibe beispielsweise eine Dicke aufweisen derart, dass eine Durchschlagspannung der Plastikscheibe die Potentialdifferenz zwischen Rohrtarget und Masse übersteigt (z.B. ungefähr 2 mm oder mehr). Anstatt der Plastikscheibe kann auch eine Scheibe aus einem anderen Dielektrikum verwendet werden.

Der erste Kondensator aus den beiden Ringsegmenten 702a (welche die Kondensatorplatten bilden) kann beispielsweise eine Kapazität von ca. 15 pF (Pikofarad) aufweisen. Der Abstand der beiden Ringsegmente 702a kann beispielsweise ungefähr 2 mm oder weniger betragen. Alternativ oder zusätzlich können die beiden Ringsegmente 702a einen Außenradius von ungefähr 110 mm und einen inneren Radius von ungefähr 60 mm (Millimeter aufweisen, z.B. bei einem Winkel von ungefähr 180°.

Im Rohrtarget kann eine ähnliche Anordnung zweier Ringsegmente 702a einen zweiten Kondensator bilden. Der zweite Kondensator kann dem Kühlfluid ausgesetzt sein, beispielsweise so dass das Kühlfluid zwischen den zwei Ringsegmenten (welche die Kondensatorplatten bilden) eindringt (anschaulich da sich dieser zweite Kondensator im Rohrtarget befindet). Im Fall von Wasser als Kühlfluid und dessen Epsilon-Wert von ungefähr 80 bis 100 ergibt sich für den zweiten Kondensator eine größere Kapazität, z.B. ungefähr 200 pF. Die beiden Kondensatoren sind mittels eines elektrisch nach außen isolierten Drahtes durch die Scheibe 704 (z.B. Targetdeckelflansch 704) hindurch miteinanderverbunden und bilden somit elektronisch zwei in Reihe geschaltete Kondensatoren.

Die Kapazität der zwei Kondensatoren ändert sich aufgrund der Rotation des Rohrtargets in deren Takt. Auf den feststehenden Scheiben 702, 706 befindet sich optional jeweils noch ein um 180° versetztes zweites Ringsegment 702b. Das zweite Ringsegment 702b kann einen zweiten Übertragungskanal (z.B. Rückkanal) bereitstellen. Rotationssynchron kann jeweils einer der beiden Kanäle als Übertragungskanal für die bidirektionale Übertragung benutzt.

Im Betrieb der Magnetronanordnung 100 kann die Kopplungsblende 704 relativ zu der ersten Scheibe 702 und der zweiten Scheibe 706 rotieren. Dies implementiert einen Drehkondensator 602 als Kommunikationsschnittstelle 602, welcher die zwei Kommunikationskanäle 701a, 701b abwechselnd herstellt bzw. unterbricht. Auf diese Weise ist immer nur einer der zwei Kommunikationskanäle 701a, 701b verbunden und zwar innerhalb eines Rotationswinkels des Rohrtargets 302.

Anschaulich kann der Drehkondensator einen Stator aufweisen mittels der zweiten Scheibe 706 bereitgestellt und einen Rotor aufweisen mittels der Kopplungsblende 704 bereitgestellt.

Die zwei Ringsegmente 702a, 702b ermöglichen die Übertragung des Steuersignals zu (mittels Ringsegment 702a) bzw. von (mittels Ringsegment 702b) den Stellgliedern 106.

Grundsätzlich kann der Aufbau des Drehkondensators 602 auch weniger komplex oder auch komplexer sein. Sollen beispielsweise mehr als zwei Kommunikationskanäle 701a, 701b bereitgestellt werden, können die Segmentwinkel entsprechen dem Vielfachen der Kommunikationskanäle 701a, 701b kleiner sein. Alternativ oder zusätzlich können auch Vollringe oder Segmente mehrerer Ringe als Kondensatorplatten verwendet werden, z.B. um mehrere Kommunikationskanäle gleichzeitig zueinander herzustellen.

Allgemeiner gesprochen kann die Kommunikationsschnittstelle 602 eine erste Komponente (auch als Rotor oder Kontaktrotor bezeichnet) aufweisen, welche relativ zu dem Träger 102 ortsfest gelagert ist. Die Kopplungsvorrichtung 602 kann ferner eine zweite Komponente (auch als Stator oder Kontaktstator bezeichnet) aufweisen, welche ortsfest relativ zu dem Rohrtarget 302 bzw. (wenn das Rohrtarget 302 noch nicht montiert ist) zu der das Rohrtarget 302 antreibenden Komponente des Antriebsstrangs 302a gelagert ist. Der Kontaktrotor und der Kontaktstator können beispielsweise im Betrieb einen Abstand voneinander aufweisen und/oder galvanisch voneinander separiert sein.

Der Kontaktrotor und der Kontaktstator können sich beispielsweise in der Anzahl ihrer Kondensatorplatten voneinander unterscheiden. Beispielsweise kann im Betrieb eine Kondensatorplatte des Kontaktrotors die Kondensatorplatten des Kontaktstators abwechselnd bzw. nacheinander einkoppeln oder andersherum.

Es kann verstanden werden, dass nicht unbedingt zwei in Reihe geschaltete Kondensatoren verwendet werden müssen. Grundsätzlich kann die Kopplungsblende 704 alternativ oder zusätzlich zu Kondensatorplatten ein Kondensatordielektrikum aufweisen, welches die Kondensatorplatten der feststehenden (auch als ortsfesten bezeichnet) Komponenten 702, 706 dielektrisch miteinander koppelt. Das Kondensatordielektrikum kann eine entsprechend hohe Permittivität aufweisen, z.B. größer als die von Wasser oder zumindest größer als 40.

Im Fall einer ohmschen Kopplung zum Einkoppeln des Steuersignals können die erste Scheibe 702 und die zweite Scheibe 706 jeweils zwei Kontakte 702a, 702b aufweisen, z.B. in Form von einander fortsetzender Ringsegmente (d.h. Segmente eines Rings). Die zwei Kontakte 702a, 702b können denselben Segmentwinkel aufweisen, z.B. in einem Bereich von ungefähr 140° bis ungefähr 180°.

In ähnlicher Weise kann die Kopplungsblende 704 ein Ringsegment aufweisen, welches in seiner Form zu den Ringsegmenten der ersten Scheibe 702 und der zweiten Scheibe 706 korrespondiert.

Im Betrieb der Magnetronanordnung 100 kann die Kopplungsblende 704 relativ zu der ersten Scheibe 702 und der zweiten Scheibe 706 rotieren. Dies implementiert einen Drehkontakt 602 als Kommunikationsschnittstelle 602, welcher die zwei Kommunikationskanäle 701a, 701b abwechselnd herstellt bzw. unterbricht. Auf diese Weise ist immer nur einer der zwei Kommunikationskanäle 701a, 701b verbunden und zwar innerhalb eines Rotationswinkels des Rohrtargets 302.

Anschaulich kann der Drehkontakt einen Stator aufweisen mittels der zweiten Scheibe 706 bereitgestellt und einen Rotor aufweisen mittels der Kopplungsblende 704 bereitgestellt.

Die zwei Kontakte 702a, 702b ermöglichen die Übertragung des Steuersignals zu (mittels Kontakt 702a) bzw. von (mittels Kontakt 702b) den Stellgliedern 106.

Grundsätzlich kann der Aufbau des Drehkontakts 602 auch weniger komplex oder auch komplexer sein. Sollen beispielsweise mehr als zwei Kommunikationskanäle 701a, 701b bereitgestellt werden, können die Segmentwinkel entsprechen dem Vielfachen der Kommunikationskanäle 701a, 701b kleiner sein. Alternativ oder zusätzlich können auch Vollringe oder Segmente mehrerer Ringe als Kontakte verwendet werden, z.B. um mehrere Kommunikationskanäle gleichzeitig zueinander herzustellen.

Allgemeiner gesprochen kann die Kommunikationsschnittstelle 602 eine erste Komponente (auch als Rotor oder Kontaktrotor bezeichnet) aufweisen, welche relativ zu dem Träger 102 ortsfest gelagert ist. Die Kopplungsvorrichtung 602 kann ferner eine zweite Komponente (auch als Stator oder Kontaktstator bezeichnet) aufweisen, welche ortsfest relativ zu dem Rohrtarget 302 bzw. (wenn das Rohrtarget 302 noch nicht montiert ist) zu der das Rohrtarget 302 antreibenden Komponente des Antriebsstrangs 302a gelagert ist. Der Kontaktrotor und der Kontaktstator können beispielsweise im Betrieb aufeinander abgleiten.

Der Kontaktrotor und der Kontaktstator können sich beispielsweise in der Anzahl ihrer Kontakte voneinander unterscheiden. Beispielsweise kann im Betrieb ein Kontakt des Kontaktrotors die Kontakte des Kontaktstators abwechselnd bzw. nacheinander berühren oder andersherum.

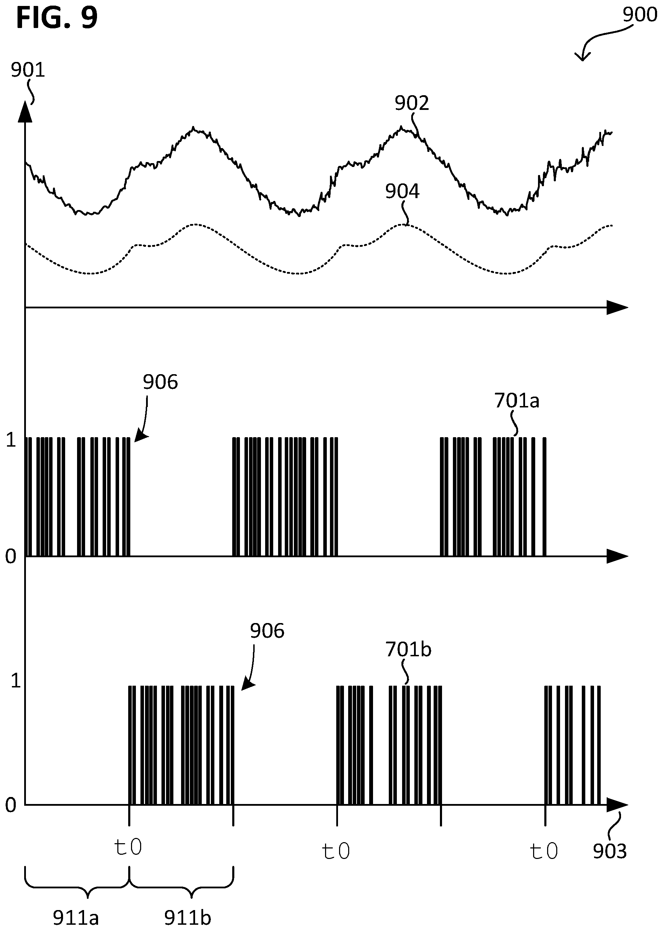

**Fig.9** veranschaulicht das Steuersignal der Magnetronanordnung 100 gemäß verschiedenen Ausführungsformen in einem schematischen Diagramm 900, in welchem eine elektrische Größe 901 des Steuersignals (z.B. dessen Spannung oder Strom) über der Zeit 903 aufgetragen ist. Die Umlaufzeit (Periodendauer der Drehbewegung) des Rohrtargets 302 ist hier als t0 angegeben. Aufgrund der Drehbewegung des Rohrtargets 302 kann das Steuersignal 902 einer Störung 904 (auch als Störsignal 904 bezeichnet) unterliegen, auf welche die eigentliche Kommunikation aufmoduliert wird. Die Kommunikation kann beispielsweise digital erfolgen, so dass eine Sequenz von Impulsen 906 übertragen wird, deren Amplitude die zu übertragenden Daten, z.B. Bits (z.B. 0 oder 1), kodiert. Wird das Störsignal 904 abgezogen, kann die Sequenz von Impulsen 906 rekonstruiert werden. Dies erreicht eine größere Zuverlässigkeit der Kommunikation.

Die getaktete Kommunikation weist auf, dass die Kommunikation über den hinführenden Kommunikationskanal 701a in einer ersten Phase 911a der Periodendauer der Drehbewegung erfolgt; und dass die Kommunikation über den rückführenden Kommunikationskanal 701b in einer zweiten Phase der Periodendauer der Drehbewegung (z.B. nach der ersten Phase oder davor) erfolgt.

Die Umlaufzeit t0 der Drehbewegung des Rohrtargets 302 kann beispielsweise in einem Bereich von ungefähr 0,01 s bis ungefähr 1 s (Sekunde) sein. Mit anderen Worten kann die Drehzahl (d.h. das Inverse der Umlaufzeit t0) in einem Bereich sein von ungefähr 1 Hz bis ungefähr 100 Hz (Hertz). Beispielsweise kann die Drehzahl ungefähr 10 Hz sein.

Beispielsweise kann das Getriebe mehrere Getriebestufen aufweisen, die sich beispielsweise in ihrem Übersetzungsverhältnis voneinander unterscheiden. Beispielsweise kann das Getriebe eine erste Getriebestufe mit einem ersten Übersetzungsverhältnis aufweisen in einem Bereich von ungefähr 2 bis ungefähr 4, z.B. ungefähr 2. Die erste Getriebestufe kann beispielsweise einen Zahnkranz mit ungefähr 120 mm Durchmesser und ein Ritzel mit ungefähr 30 mm Durchmesser aufweisen. Alternativ oder zusätzlich kann das Getriebe eine zweite Getriebestufe mit einem zweiten Übersetzungsverhältnis aufweisen von mehr als das erste Übersetzungsverhältnis und/oder von mehr als ungefähr 10, von mehr als ungefähr 25, oder von mehr als ungefähr 50. Beispielsweise kann das zweite Übersetzungsverhältnis ungefähr 66 sein.

Die zweite Getriebestufe kann die Rotationsbewegung auf den Rotor des Generators übertragen, so dass beispielsweise 24 V bei 5000 U/min und/oder maximal 50 Watt bereitgestellt werden.

Optional kann der Generator zumindest einen (d.h. einen oder mehr als einen) Superkondensator (z.B. mittels Helmholtz-Doppelschichten bereitgestellt) aufweisen zum Zwischenspeichern der erzeugten Leistung des Generators. Beispielsweise kann der zumindest eine Superkondensator gemäß einer Sequenz betrieben werden, welcher mehrere Phasen aufweist, von denen eine erste Phase aufweist, dem zumindest einen Superkondensator elektrische Leistung (der Drehbewegung des Targets entnommen) zuzuführen, und von denen eine zweite Phase aufweist, von dem zumindest einen Superkondensator elektrische Leistung an ein oder mehr als ein Stellglied abzugeben. Die zweite Phase kann kürzer sein als die erste Phase, z.B. die Hälfte der ersten Phase oder kürzer, z.B. ein Fünftel der ersten Phase oder kürzer. Beispielsweise kann die erste Phase (auch als Ladephase bezeichnet) eine Dauer von 20 s oder mehr aufweisen. Beispielsweise kann die zweite Phase (auch als Entladephase bezeichnet) eine Dauer von 2 s oder weniger aufweisen. Dies erreicht, den Generator noch kleiner bauen zu können und/oder bestehende Systeme umrüsten zu können, ohne deren Rohrtarget-Antrieb (auch als Targetantrieb bezeichnet) wechseln zu müssen.

In einem Beispiel ist das Drehmoment M zum Antrieb des Generators (gemäß P=M·ω) ungefähr 10 W/(2·π·15 U/min), d.h. ungefähr 6 Nm (Newtonmeter), wobei ω die Winkelgeschwindigkeit und P die Leistung ist. Ein Targetantrieb kann beispielsweise ungefähr 40 Nm oder weniger liefern. Beispielsweise kann das mittels des Generators auf das Rohrtarget übertragene Drehmoment in einem Bereich sein von ungefähr 0,5 Nm bis ungefähr 1 Nm. Dazu kann die Energiegewinnung mittels des Generators geregelt betrieben werden (z.B. mittels der Steuervorrichtung), so dass der Generator der Drehbewegung des Rohrtargets ungefähr 1 W oder weniger entzieht.

Im Folgenden werden verschiedene Beispiele beschrieben, die sich auf vorangehend Beschriebene und in den Figuren Dargestellte beziehen.

Beispiel 1 ist eine Magnetronanordnung gemäß dem Patentanspruch 1, unter anderem aufweisend: eine Lageranordnung, welche einen (z.B. längserstreckten) Träger (z.B. ein Trägerrohr) aufweist, zum Lagern eines rohrförmigen Targets, in welchem der Träger der Lageranordnung entlang erstreckt (z.B. in dieses hineinerstreckt) ist; eine oder mehr als eine Magnetsystemgruppe (z.B. mehrere Magnetsystemgruppen), welche mehrere Magneten und ein elektrisches Stellglied aufweist, wobei das Stellglied eingerichtet ist, eine Lage der mehreren Magneten relativ zu dem Träger in Antwort auf ein dem Stellglied zugeführtes elektrisches Steuersignal zu stellen; einen elektrischen Generator, welcher eingerichtet ist, elektrische Leistung basierend auf einer Drehbewegung des Targets bereitzustellen (z.B. die Drehbewegung in die elektrische Leistung umzuwandeln) und dem Stellglied zuzuführen.

Beispiel 2 ist eine Magnetronanordnung gemäß dem Patentanspruch 1, unter anderem aufweisend: eine Lageranordnung, welche einen (z.B. längserstreckten) Träger (z.B. ein Trägerrohr) aufweist, zum (z.B. drehbaren oder ortsfesten) Lagern eines (z.B. rohrförmigen oder plattenförmigen) Targets, in welchem der Träger der Lageranordnung entlang erstreckt (z.B. in dieses hineinerstreckt) ist; mehrere Magnetsystemgruppen (auch als Magnetsystemsegment bezeichnet), welche hintereinander angeordnet und mit dem Träger gekuppelt sind und von denen jede Magnetsystemgruppe aufweist: eine Rückschlussplatte, mehrere (z.B. drei) Magneten, welche mittels der Rückschlussplatte magnetisch miteinander gekoppelt sind; (z.B. genau) ein elektrisches Stellglied, welches eingerichtet ist, eine Lage der Rückschlussplatte relativ zu dem Träger in Antwort auf ein dem Stellglied zugeführtes elektrisches Steuersignal zu stellen.

Beispiel 3 ist eine Magnetronanordnung gemäß dem Patentanspruch 1, unter anderem aufweisend: eine Lageranordnung, welche einen Träger (z.B. ein Trägerrohr) aufweist, zum Lagern eines Targets, in welches der Träger hineinerstreckt ist; eine oder mehr als eine Magnetsystemgruppe (z.B. mehrere Magnetsystemgruppen), von denen jede Magnetsystemgruppe aufweist: eine optionale Rückschlussplatte, mindestens drei Magneten, (z.B. genau) ein elektrisches Stellglied, welches eingerichtet ist, eine Lage der Rückschlussplatte und/oder der mindestens drei Magneten relativ zu dem Träger in Antwort auf ein dem Stellglied zugeführtes elektrisches Steuersignal zu stellen; einen elektrischen Generator, welcher eingerichtet ist, elektrische Leistung basierend auf einer Drehbewegung des Targets bereitzustellen (z.B. die Drehbewegung in die elektrische Leistung umzuwandeln) und dem Stellglied zuzuführen.

Beispiel 4 ist die Magnetronanordnung gemäß einem der Beispiele 1 bis 3, wobei eine Anzahl der mehreren Magnetsystemgruppen größer ist als eine Anzahl von Magneten pro Magnetsystemgruppe und/oder wobei die Anzahl der Magnetsystemgruppen 10 oder mehr ist (z.B. 15 oder mehr ist); und/oder wobei die Anzahl der Magnetsystemgruppen 20 oder weniger ist (z.B. 16).

Beispiel 5 ist die Magnetronanordnung gemäß einem der Beispiele 1 bis 4, - ferner aufweisend: eine oder mehr als eine zusätzliche Magnetsystemgruppe (z.B. passive Magnetsystemgruppe), von denen jede zusätzliche Magnetsystemgruppe zwischen zwei einander unmittelbar benachbarten Magnetsystemgruppen der mehreren Magnetsystemgruppen angeordnet ist und eine Rückschlussplatte aufweist, die mit der Rückschlussplatte der zwei einander unmittelbar benachbarten Magnetsystemgruppen gekuppelt ist, wobei optional jede der zwei einander unmittelbar benachbarten Magnetsystemgruppen zumindest ein Stellglied mehr aufweist als jede zusätzliche Magnetsystemgruppe.

Beispiel 6, siehe beispielsweise auch die Magnetronanordnung gemäß dem Anspruch 14, ist die Magnetronanordnung gemäß einem der Beispiele 1 bis 5, wobei jede Magnetsystemgruppe genau ein elektrisches Stellglied aufweist; und/oder wobei jede zusätzliche Magnetsystemgruppe frei ist von einem Stellglied.

Beispiel 7, siehe beispielsweise auch die Magnetronanordnung gemäß dem Anspruch 2, ist die Magnetronanordnung gemäß einem der Beispiele 1 bis 6, wobei die Lageranordnung einen Antriebsstrang aufweist zum Antreiben der Drehbewegung des Targets (z.B. wenn diese rohrförmig ist).

Beispiel 8 ist die Magnetronanordnung gemäß einem der Beispiele 1 bis 7, wobei der Generator mittels des Trägers abgestützt wird.

Beispiel 9 ist die Magnetronanordnung gemäß einem der Beispiele 1 bis 8, wobei das elektrische Stellglied einen elektrischen Aktor (z.B. Motor oder Piezoelement) aufweist oder daraus gebildet ist.

Beispiel 10 ist die Magnetronanordnung gemäß einem der Beispiele 1 bis 9, wobei der Träger ein Rohr (auch als Lanzenrohr bezeichnet) aufweist oder daraus gebildet ist (z.B. wenn das Target rohrförmig ist); oder wobei der Träger einen Rahmen aufweist oder daraus gebildet ist (z.B. wenn das Target plattenförmig ist).

Beispiel 11 ist die Magnetronanordnung gemäß einem der Beispiele 1 bis 10, wobei die Lageranordnung einen (in Cantilever-Konfiguration) oder mehr als einen Aufnahmebereich zum Lagern des Targets aufweist (z.B. jeder Aufnahmebereich mittels eines Endblocks bereitgestellt).

Beispiel 12, siehe beispielsweise auch die Magnetronanordnung gemäß dem Anspruch 3, ist die Magnetronanordnung gemäß einem der Beispiele 1 bis 11, wobei die Lageranordnung einen ersten Endblock und/oder einen zweiten Endblock aufweist, zwischen denen beispielsweise der Generator angeordnet ist; wobei beispielsweise jeder Endblock der Lageranordnung eine relativ zu dem Träger drehbar gelagerte Kupplungsvorrichtung zum Ankuppeln des rohrförmigen Targets aufweist.

Beispiel 13 ist die Magnetronanordnung gemäß Beispiel 12, wobei der erste Endblock einen oder den Antriebsstrang zum Übertragen eines Drehmoments auf die Kupplungsvorrichtung aufweist; und/oder wobei der zweite Endblock mehrere Fluidleitungen zum Austauschen eines Fluids mittels der Kupplungsvorrichtung aufweist (z.B. zum Austauschen zwischen dem Träger und dem zweiten Endblock).

Beispiel 14 ist die Magnetronanordnung gemäß einem der Beispiele 1 bis 13, ferner aufweisend: eine Steuervorrichtung, welche eingerichtet ist, das Stellglied jeder Magnetsystemgruppe anzusteuern, z.B. basierend auf einem Ist-Zustand eines mittels der Magnetronanordnung durchgeführten Prozesses (z.B. Beschichtungsprozesses).

Beispiel 15 ist die Magnetronanordnung gemäß Beispiel 14, wobei die Steuervorrichtung eingerichtet ist, das Stellglied jeder Magnetsystemgruppe sequentiell anzusteuern.

Beispiel 16 ist die Magnetronanordnung gemäß einem der Beispiele 1 bis 15, wobei die Kommunikationsschnittstelle eine Komponente eines Targetdeckels ist. Beispiel 17, siehe beispielsweise auch die Magnetronanordnung gemäß dem Anspruch 1, ist die Magnetronanordnung gemäß Beispiel 16, wobei die Kommunikationsschnittstelle den diskontinuierlichen

Drehkondensator aufweist, welcher mechanisch mit der Drehbewegung gekuppelt ist.

Beispiel 18 ist die Magnetronanordnung gemäß Beispiel 17, wobei der Drehkondensator eine gebrochene Drehsymmetrie und/oder eine Spiegelsymmetrie aufweist und/oder mehrzählig eingerichtet ist; und/oder wobei der Drehkondensator einen Stator und einen Rotor aufweist, wobei der Stator ortsfest relativ zu dem Träger eingerichtet ist und wobei der Rotor zum Ankuppeln an die Drehbewegung beweglich relativ zu dem Träger eingerichtet ist.

Beispiel 19 ist die Magnetronanordnung gemäß Beispiel 18, wobei der Stator und/oder der Rotor des Drehkondensators ein Ringsegment aufweisen, wobei das Ringsegment beispielsweise einen Segmentwinkel von 270° oder weniger (z.B. 180° oder weniger) aufweist.

Beispiel 20, siehe beispielsweise auch die Magnetronanordnung gemäß dem Anspruch 10, ist die Magnetronanordnung gemäß einem der Beispiele 1 bis 19, wobei das Stellglied ein selbsthemmendes Getriebe aufweist, wobei beispielsweise das selbsthemmende Getriebe einen oder den Gleitkeil und/oder ein selbsthemmendes Gewinde aufweist.

Beispiel 21 ist die Magnetronanordnung gemäß einem der Beispiele 1 bis 20, wobei eine Anzahl Magnete pro Stellglied sieben oder weniger ist, z.B. sechs oder weniger ist, z.B. drei oder weniger.

Beispiel 22, siehe beispielsweise auch die Magnetronanordnung gemäß dem Anspruch 4, ist die Magnetronanordnung gemäß einem der Beispiele 1 bis 21, wobei der elektrische Generator ein Getriebe aufweist, welches eingerichtet ist, die dem Generator eingekoppelte Drehbewegung des Targets erster Drehzahl in eine Drehbewegung zweiter Drehzahl zu überführen, wobei die zweite Drehzahl verschieden ist von der (z.B. größer als die) ersten Drehzahl.

Beispiel 23 , siehe beispielsweise auch die Magnetronanordnung gemäß dem Anspruch 5, ist die Magnetronanordnung gemäß Beispiel 22, wobei das Getriebe ein Planetengetriebe aufweist oder daraus gebildet ist.

Beispiel 24 ist die Magnetronanordnung gemäß einem der Beispiele 1 bis 23, wobei eine elektrische Leistung des elektrischen Generators in einem Bereich von ungefähr 1 Watt bis ungefähr 50 Watt ist, z.B. in einem Bereich von ungefähr 10 Watt bis ungefähr 50 Watt.

Beispiel 25, siehe beispielsweise auch die Magnetronanordnung gemäß dem Anspruch 13, ist die Magnetronanordnung gemäß einem der Beispiele 1 bis 24, wobei alle Magneten (optional zusammen mit der Rückschlussplatte) jeder Magnetsystemgruppe zusammen ein Gewicht von weniger als 500 Gramm (z.B. 100 Gramm) aufweisen.

Beispiel 26 ist die Magnetronanordnung gemäß einem der Beispiele 1 bis 25, wobei eine Ausdehnung jeder Magnetsystemgruppe (entlang einer Drehachse der Drehbewegung) ungefähr 10 cm (Zentimeter) ist oder weniger, z.B. ungefähr 5 cm oder weniger, z.B. ungefähr 1 cm oder weniger; oder in einem Bereich von ungefähr 4 cm bis 10 cm ungefähr, z.B. ungefähr 6 cm.

Beispiel 27, siehe beispielsweise auch die Magnetronanordnung gemäß dem Anspruch 14 oder 15, ist die Magnetronanordnung gemäß einem der Beispiele 1 bis 26 , wobei jede Magnetsystemgruppe magnetisch dreipolig ist (d.h. drei magnetische Pole aufweist), wobei beispielsweise jeder magnetische Pol einen der Magneten aufweist oder daraus gebildet ist, oder wobei beispielsweise jeder magnetische Pol einen Satz Magneten aufweist, deren Länge beispielsweise ein ganzzahliges Vielfaches (z.B. die Länge der Magnetsystemgruppe) aufweist (z.B. wenn sich die Sätze in der Länge der Magneten voneinander unterscheiden). Beispielsweise kann der innere Pol drei jeweils 20 mm lange Magneten aufweisen und jeder äußere Pol kann zwei jeweils 30 mm lange Magneten aufweisen (so dass die Magnetsystemgruppe genau 7 Magnete aufweist).

Beispiel 28 ist die Magnetronanordnung gemäß einem der Beispiele 1 bis 27, wobei der elektrische Generator einen Stator aufweist durch welchen der Träger hindurch erstreckt ist; und/oder wobei der elektrische Generator einen Rotor aufweist durch welchen der Träger hindurch erstreckt ist.

Beispiel 29 ist die Magnetronanordnung gemäß Beispiel 28, ferner aufweisend: das Target, welches beispielsweise den Rotor des Generators aufweist oder den Rotor des Generators zumindest hält.

Beispiel 30 ist die Magnetronanordnung gemäß einem der Beispiele 1 bis 29, wobei der elektrische Generator neben dem Träger angeordnet ist.

Beispiel 31, siehe beispielsweise auch die Magnetronanordnung gemäß dem Anspruch 6, ist die Magnetronanordnung gemäß einem der Beispiele 1 bis 30, wobei das Stellglied ein Scherengetriebe aufweist.

Beispiel 32 ist die Magnetronanordnung gemäß einem der Beispiele 1 bis 31, wobei das Stellglied ein Lineargetriebe aufweist.

Beispiel 33, - siehe beispielsweise auch die Magnetronanordnung gemäß dem Anspruch 7, ist die Magnetronanordnung gemäß einem der Beispiele 1 bis 32, wobei das Stellglied einen Gleitkeil aufweist, welcher beispielsweise eingerichtet ist, die Lage der mehreren Magneten relativ zu dem Träger in Antwort auf eine auf dem Gleitkeil übertragene Bewegung zu stellen (z.B. mittels eines Stempels).

Beispiel 34 ist die Magnetronanordnung gemäß einem der Beispiele 1 bis 33, wobei eine pro Stellglied aufgenommene elektrische Leistung beim Verstellen der Lage der Rückschlussplatte relativ zu dem Träger in einem Bereich von ungefähr 50% (z.B. 75%) bis ungefähr 100% einer Nennleistung des Generators oder mehr als die Nennleistung des Generators ist.

Beispiel 35 ist die Magnetronanordnung gemäß Beispiel 34, ferner aufweisend: zumindest einen Superkondensator, welcher abwechselnd mit dem Generator und einem Stellglied gekoppelt wird.

Beispiel 36 ist die Magnetronanordnung gemäß Beispiel 35, wobei der zumindest eine Superkondensator gemäß einer Sequenz abwechselnd mit dem Generator und dem Stellglied gekoppelt wird (z.B. von einer Steuervorrichtung gesteuert), wobei der Zyklus eine erste Phase aufweist, in welcher der Generator dem Superkondensator ein erste elektrische Leistung zuführt, wobei der Zyklus eine zweite Phase aufweist, in welcher der Superkondensator dem Stellglied eine zweite elektrische Leistung zuführt, wobei beispielsweise die zweite Phase kürzer ist als die erste Phase und/oder wobei die zweite Leistung größer ist als die erste Leistung.

Beispiel 37 ist die Magnetronanordnung gemäß einem der Beispiele 1 bis 36, welche frei von einem elektrochemischen Energiespeicher ist.

Beispiel 38 ist die Magnetronanordnung gemäß einem der Beispiele 1 bis 37, welche frei von einem kapazitiven Energiespeicher ist (der beispielsweise zwischen eine Spule des Generators und einem Stellglied gekoppelt ist).

Beispiel 39 ist die Magnetronanordnung gemäß einem der Beispiele 1 bis 38, welche frei von einer kapazitiven Speicherkapazität ist, die größer ist als ungefähr 50% (z.B. 75%) einer beim Stellen der Lage der Rückschlussplatte pro Stellglied aufgenommenen Energie. Beispiel 40 ist eine Prozessieranordnung, aufweisend: eine Vakuum-Prozessierkammer; und eine in der Vakuum-Prozessierkammer angeordnete Magnetronanordnung gemäß einem der Beispiele 1 bis 39.

Beispiel 41 ist die Prozessieranordnung gemäß Beispiel 40, aufweisend: eine außerhalb der Vakuum-Prozessierkammer angeordnete Steuervorrichtung, welche eingerichtet ist, der Magnetronanordnung das Steuersignal zuzuführen und/oder einen Arbeitspunkt des Generators zu steuern und/oder zu regeln; und/oder eine Transportvorrichtung zum Transportieren eines Substrats zu der Magnetronanordnung hin, von dieser weg oder an dieser vorbei.

Beispiel 42 ist die Prozessieranordnung gemäß Beispiel 41, wobei die Steuervorrichtung eingerichtet ist, den Arbeitspunkt des Generators zu regeln, z.B. basierend auf einer Eingangsgröße, welche eine Drehzahl des Targets repräsentiert, und/oder gemäß einer elektrischen Soll-Leistung des Generators.

## Patentansprüche

1. Magnetronanordnung (100), aufweisend:
• eine Lageranordnung, welche einen Träger (102) aufweist, zum drehbaren Lagern eines rohrförmigen Targets (302), in welches der Träger (102) hineinerstreckt ist;
• eine Magnetsystemgruppe (150), welche mehrere Magneten (104) und ein elektrisches Stellglied aufweist, wobei das Stellglied eingerichtet ist, eine Lage der mehreren Magneten (104) relativ zu dem Träger (102) in Antwort auf ein dem Stellglied zugeführtes elektrisches Steuersignal zu stellen;
• einen elektrischen Generator (308), welcher eingerichtet ist, eine Drehbewegung des Targets (302) in elektrische Leistung umzuwandeln und dem Stellglied zuzuführen;
**gekennzeichnet dadurch, dass** die Magnetronanordnung (100) weiter aufweist:
• eine Kommunikationsschnittstelle (602), welche eingerichtet ist, das elektrische Steuersignal getaktet gemäß der Drehbewegung des Targets (302) dem Stellglied zuzuführen;
• wobei die Kommunikationsschnittstelle (602) einen Drehkondensator aufweist, welcher mit der Drehbewegung gekuppelt ist.

2. Magnetronanordnung (100) gemäß Anspruch 1, wobei die Lageranordnung einen Antriebsstrang (302a) aufweist zum Antreiben der Drehbewegung.

3. Magnetronanordnung (100) gemäß Anspruch 1 oder 2, wobei die Lageranordnung einen ersten Endblock (312a) und einen zweiten Endblock (312b) aufweist, zwischen denen der Generator angeordnet ist.

4. Magnetronanordnung (100) gemäß einem der Ansprüche 1 bis 3,
wobei der elektrische Generator (308) ein Getriebe aufweist, welches eingerichtet ist, die dem Generator (308) eingekoppelte Drehbewegung des Targets (302) erster Drehzahl in eine Drehbewegung zweiter Drehzahl zu überführen, wobei die zweite Drehzahl verschieden ist von der ersten Drehzahl.

5. Magnetronanordnung (100) gemäß Anspruch 4, wobei das Getriebe ein Planetengetriebe aufweist oder daraus gebildet ist.

6. Magnetronanordnung (100) gemäß einem der Ansprüche 1 bis 5, wobei das Stellglied ein Scherengetriebe aufweist.

7. Magnetronanordnung (100) gemäß einem der Ansprüche 1 bis 6, wobei das Stellglied einen Gleitkeil aufweist, welcher eingerichtet ist, die Lage der mehreren Magneten (104) relativ zu dem Träger (102) in Antwort auf eine auf dem Gleitkeil übertragene Bewegung zu stellen.

8. Magnetronanordnung (100) gemäß einem der Ansprüche 1 bis 7, wobei eine pro Stellglied aufgenommene elektrische Leistung in einem Bereich von ungefähr 50% bis ungefähr 100% einer Nennleistung des Generators (308) ist.

9. Magnetronanordnung (100) gemäß einem der Ansprüche 1 bis 8, welche frei von einem elektrochemischen Energiespeicher ist.

10. Magnetronanordnung (100) gemäß einem der Ansprüche 1 bis 9, wobei das Stellglied ein selbsthemmendes Getriebe aufweist, wobei das selbsthemmende Getriebe vorzugsweise ein selbsthemmendes Gewinde aufweist.

11. Magnetronanordnung (100) gemäß einem der Ansprüche 1 bis 10, wobei die Magnetsystemgruppe (150) eine Rückschlussplatte aufweist, mittels welcher die mehrere Magneten (104) magnetisch miteinander gekoppelt sind.

12. Magnetronanordnung (100) gemäß einem der Ansprüche 1 bis 11, ferner aufweisend:
mehreren Magnetsystemgruppen (150), welche die Magnetsystemgruppe (150) mehrfach aufweisen, wobei die mehreren Magnetsystemgruppen (150):
• eine Anzahl der Magnetsystemgruppen (150) von größer als 10 aufweisen; und/oder
• hintereinander angeordnet und mit dem Träger (102) gekuppelt sind.

13. Magnetronanordnung (100) gemäß einem der Ansprüche 1 bis 12, wobei alle Magneten der Magnetsystemgruppe (150) ein Gewicht von weniger als 500 Gramm aufweisen.

14. Magnetronanordnung (100) gemäß einem der Ansprüche 1 bis 13,
• wobei die Magnetsystemgruppe (150) genau drei magnetische Pole aufweist; und/oder
• wobei die Magnetsystemgruppe (150) genau das eine elektrische Stellglied aufweist.

15. Magnetronanordnung (100) gemäß Anspruch 14, wobei jeder magnetische Pol der drei magnetischen Pole einen Satz Magneten (104) aufweist, deren Länge ein ganzzahliges Vielfaches voneinander aufweist.

## Claims

1. Magnetron assembly (100), comprising:
• a bearing assembly comprising a carrier (102) for rotatably supporting a tubular target (302) into which the carrier (102) is extended;
• a magnet system group (150) comprising multiple magnets (104) and an electrical actuator, the actuator being configured to adjust a position of the several magnets (104) relative to the carrier (102) in response to an electrical control signal supplied to the actuator;
• an electrical generator (308) configured to convert a rotational motion of the target (302) into electrical power and supply it to the actuator;
**characterized in that** the magnetron assembly (100) further comprises:
• a communication interface (602) configured to supply the electrical control signal to the actuator in a clocked manner according to the rotational motion of the target (302) ;
• wherein the communication interface (602) comprises a rotary capacitor coupled to the rotational motion.

2. Magnetron assembly (100) according to claim 1,
wherein the bearing assembly comprises a drive train (302a) for driving the rotational motion.

3. Magnetron assembly (100) according to claim 1 or 2, wherein the bearing assembly comprises a first end block (312a) and a second end block (312b) between which the generator is arranged.

4. Magnetron assembly (100) according to any one of claims 1 to 3,
wherein the electrical generator (308) comprises a transmission configured to convert the rotational motion of the target (302) of a first rotational speed coupled to the generator (308) into a rotational motion of a second rotational speed, the second rotational speed being different from the first rotational speed.

5. Magnetron assembly (100) according to claim 4,
wherein the transmission comprises a planetary gear or is formed therefrom.

6. Magnetron assembly (100) according to any one of claims 1 to 5, wherein the actuator comprises a scissor gear.

7. Magnetron assembly (100) according to any one of claims 1 to 6, wherein the actuator comprises a sliding wedge configured to manipulate the position of the several magnets (104) relative to the carrier (102) in response to a motion transmitted on the sliding wedge.

8. Magnetron assembly (100) according to any one of claims 1 to 7, wherein an electrical power consumed per actuator is in a range of about 50% to about 100% of a rated power of the generator (308).

9. Magnetron assembly (100) according to any one of claims 1 to 8, which is free of an electrochemical energy storage.

10. Magnetron assembly (100) according to any one of claims 1 to 9, wherein the actuator comprises a self-locking gear, wherein the self-locking gear preferably comprises a self-locking thread.

11. Magnetron assembly (100) according to any one of claims 1 to 10, wherein the magnet system group (150) comprises a reverse plate by which the several magnets (104) are magnetically coupled to each other.

12. Magnetron assembly (100) according to any one of claims 1 to 11, further comprising:
multiple magnet system groups (150) comprising a manifold of the magnet system group (150), wherein the several magnet system groups (150):
• comprise a number of the magnet system groups (150) greater than 10; and/or
• are arranged in series and coupled to the carrier (102).

13. Magnetron assembly (100) according to any one of claims 1 to 12, wherein all magnets of the magnet system group (150) have a weight of less than 500 grams.

14. Magnetron assembly (100) according to any one of claims 1 to 13,
• wherein the magnet system group (150) comprises exactly three magnetic poles; and/or
• wherein the magnet system group (150) comprises exactly the one electrical actuator.

15. Magnetron assembly (100) according to claim 14,
wherein each magnetic pole of the three magnetic poles comprises a set of magnets (104) having a length that is an integer multiple of each other.

## Revendications

1. Ensemble magnétron (100), comprenant :
• un ensemble de palier comprenant un support (102) pour supporter de manière rotative une cible tubulaire (302) dans laquelle le support (102) est étendu ;
• un groupe de systèmes magnétiques (150) comprenant des aimants multiples (104) et un actionneur électrique, l'actionneur étant configuré pour ajuster une position des plusieurs aimants (104) par rapport au support (102) en réponse à un signal de commande électrique fourni à l'actionneur ;
• un générateur électrique (308) configuré pour convertir un mouvement de rotation de la cible (302) en puissance électrique et pour la fournir à l'actionneur ;
**caractérisé en ce que** l'ensemble magnétron (100) comprend en outre :
• une interface de communication (602) qui est configurée pour fournir le signal de commande électrique à l'actionneur de manière cadencée en fonction du mouvement de rotation de la cible (302) ;
• l'interface de communication (602) comprenant un condensateur rotatif qui est couplé au mouvement de rotation.

2. Ensemble magnétron (100) selon la revendication 1, dans lequel l'ensemble de palier comprend un groupe d'entraînement (302a) pour entraîner le mouvement de rotation.

3. Ensemble magnétron (100) selon la revendication 1 ou 2, dans lequel l'ensemble de palier comprend un premier bloc d'extrémité (312a) et un deuxième bloc d'extrémité (312b) entre lesquels le générateur est disposé.

4. Ensemble magnétron (100) selon l'une quelconque des revendications 1 à 3,
dans lequel le générateur électrique (308) comporte un engrenage configuré pour convertir le mouvement de rotation de la cible (302) de première vitesse de rotation couplé au générateur (308) en un mouvement de rotation de deuxième vitesse de rotation, la deuxième vitesse de rotation étant différente de la première vitesse de rotation.

5. Ensemble magnétron (100) selon la revendication 4, dans lequel l'engrenage comprend un engrenage planétaire ou est formé de celui-ci.

6. Ensemble magnétron (100) selon l'une quelconque des revendications 1 à 5, dans lequel l'actionneur comprend un engrenage à ciseaux.

7. Ensemble magnétron (100) selon l'une quelconque des revendications 1 à 6, dans lequel l'actionneur comprend une cale coulissante configurée pour manipuler la position des plusieurs aimants (104) par rapport au support (102) en réponse à un mouvement transmis sur la cale coulissante.

8. Ensemble magnétron (100) selon l'une quelconque des revendications 1 à 7, dans lequel une puissance électrique consommée par actionneur est comprise dans une plage allant d'environ 50% à environ 100% d'une puissance nominale du générateur (308).

9. Ensemble magnétron (100) selon l'une quelconque des revendications 1 à 8, qui est dépourvu de stockage d'énergie électrochimique.

10. Ensemble magnétron (100) selon l'une quelconque des revendications 1 à 9, dans lequel l'actionneur comprend un engrenage autobloquant, l'engrenage autobloquant comprenant de préférence un filetage autobloquant.

11. Ensemble magnétron (100) selon l'une quelconque des revendications 1 à 10, dans lequel le groupe de systèmes magnétiques (150) comprend une plaque renversée au moyen de laquelle les plusieurs aimants (104) sont couplés magnétiquement les uns aux autres.

12. Ensemble magnétron (100) selon l'une quelconque des revendications 1 à 11, comprenant en outre :
des groupes de systèmes magnétiques multiples (150) comprenant le groupe de systèmes magnétiques (150) plusieurs fois, dans lequel les plusieurs groupes de systèmes magnétiques (150) :
• comprennent un nombre de groupes de systèmes magnétiques (150) supérieur à 10 ; et/ou
• sont disposés les uns derrière les autres et sont couplés au support (102).

13. Ensemble magnétron (100) selon l'une quelconque des revendications 1 à 12, dans lequel tous les aimants du groupe de systèmes magnétiques (150) ont un poids inférieur à 500 grammes.

14. Ensemble magnétron (100) selon l'une quelconque des revendications 1 à 13,
• dans lequel le groupe de systèmes magnétiques (150) comporte exactement trois pôles magnétiques ; et/ou
• dans lequel le groupe de systèmes magnétiques (150) comprend exactement ledit un actionneur électrique.

15. Ensemble magnétron (100) selon la revendication 14, dans lequel chaque pôle magnétique des trois pôles magnétiques comprend un ensemble d'aimants (104) dont la longueur est un multiple entier de l'autre.
